# EUROPEAN PATENT SPECIFICATION

(11) **EP 4 376 576 B1**
(45) Date of publication and mention of the grant of the patent: **12.08.2026**
(21) Application number: 23211122.9
(22) Date of filing: 21.11.2023
(51) Int. Cl.: H10K 59/124, H10K 59/80, H10K 50/844, H10K 59/122

(54) **LIGHT EMITTING DISPLAY DEVICE**
LICHTEMITTIERENDE ANZEIGEVORRICHTUNG
DISPOSITIF D'AFFICHAGE ÉLECTROLUMINESCENT

(30) Priority: 21.11.2022 KR 20220156803
(43) Date of publication of application: 29.05.2024
(73) Proprietor: Samsung Display Co., Ltd., Yongin-si, Gyeonggi-do 17113 (KR)
(72) Inventor: Hong, Sang Min, Yongin-si, Gyeonggi-Do (KR); Kim, Hyo Min, Yongin-si, Gyeonggi-Do (KR); Heo, Nari, Yongin-si, Gyeonggi-do (KR)
(74) Representative: Gulde & Partner

(56) References cited:
- CN-U- 217 641 344
- US-A1- 2018 040 847
- US-A1- 2022 231 089
- US-A1- 2023 046 219

## Description

### BACKGROUND

### 1. Field

Aspects of embodiments of the present invention relate to a light emitting display device.

### 2. Description of the Related Art

A display device is a device for displaying an image and includes a liquid crystal display (LCD), an organic light emitting diode (OLED) display, and the like. The display device is used in various electronic devices, such as a mobile phone, a navigation device, a digital camera, an electronic book, a portable game machine, and various terminals as some examples.

A display device, such as an organic light emitting display device, may have a structure that can be bent or folded by including a flexible substrate.

The above information disclosed in this Background section is for enhancement of understanding of the background of the present invention, and therefore, it may contain information that does not form the prior art that is already known to a person of ordinary skill in the art.

CN 217 641 344 U relates to a light emitting display device and a manufacturing method of the light emitting display device for improving display quality by reducing reflective color bands caused by asymmetrically reflected external light. US 2018/0040847 A1 discloses an organic electroluminescence display device comprising an encapsulation layer having a first inorganic layer with multilayer structure including alternately disposed first and second layers of different refractive index. US 2022/231989 A1 discloses an OLED display with a first insulation layer having openings over the red, green and blue emissive areas that are filled with a high refractive index second insulation layer.

### SUMMARY

Embodiments of the present invention reduce or eliminate a reddish phenomenon in which excessive red color is displayed at a low angle based on the front of a light emitting display device which does not include a polarizer.

Embodiments of the present invention also improve display quality by reducing a reflective color band generated by asymmetrical reflection due to reflection of external light even without attaching a polarizer.

An embodiment according to a first aspect of the present invention, which does not form part of the appended claims, provides a light emitting display device including: a substrate; an organic film on the substrate; a green light emitting diode on the organic film and including a first anode; a red light emitting diode on the organic film and including a second anode; a black pixel defining film having an opening exposing the first anode and an opening exposing the second anode; a cathode on the black pixel defining film, the first anode, and the second anode; an encapsulation layer covering the cathode; a light blocking member on the encapsulation layer and having an opening; and a color filter filling the opening in the light blocking member. A portion of the organic film overlapping the first anode in a plan view has a halftone exposure area, and a step of the halftone exposure area is 30 nm or less.

The organic film may have an opening for anode connection that connects the first anode or the second anode, and the halftone exposure area may not overlap the opening for anode connection in the plan view.

The light emitting display device may further include a blue light emitting diode on the organic film and including a third anode, and a portion of the organic film that overlaps the second anode and the third anode in the plan view may not have a halftone exposure area and a step thereof may exceed 30 nm.

The light emitting display device may further include a second data conductive layer between the substrate and the organic film, and the organic film may include a lower organic film and an upper organic film.

The halftone exposure area arranged at a portion overlapping the first anode in the plan view may be on the lower organic film, and the halftone exposure area may not be on the upper organic film.

The light emitting display device may further include a first data conductive layer between the substrate and the second data conductive layer. The first data conductive layer may have a first extension overlapping the first anode in the plan view, and the second data conductive layer may have a plurality of second extensions respectively overlapping the second anode and the third anode in the plan view.

A polarizer may not be on the light blocking member and the color filter.

The encapsulation layer may include a first inorganic encapsulation layer, an organic encapsulation layer, and a second inorganic encapsulation layer, and the first inorganic encapsulation layer may include a (1-1)-th inorganic encapsulation layer, a (1-2)-th inorganic encapsulation layer, and a (1-3)-th inorganic encapsulation layer that have different refractive indexes and thicknesses and that are sequentially stacked.

The refractive index of the (1-2)-th inorganic encapsulation layer may be the largest from among the layers of the first inorganic encapsulation layer, the refractive index of the (1-3)-th inorganic encapsulation layer may be the next largest, and the refractive index of the (1-1)-th inorganic encapsulation layer may be the smallest, and the (1-2)-th inorganic encapsulation layer may be the thickest from among the layers of the first inorganic encapsulation layer, the (1-1)-th inorganic encapsulation layer may be the next thickest, and the (1-3)-th inorganic encapsulation layer may be the thinnest.

The first inorganic encapsulation layer may further include a (1-4)-th inorganic encapsulation layer having a low refractive index and being on the (1-3)-th inorganic encapsulation layer.

An embodiment according to a second aspect of the present invention, which forms part of the appended claims, provides a light emitting display device including: a substrate; a green light emitting diode including a first anode, a red light emitting diode including a second anode, and a blue light emitting diode including a third anode, the first, second, and third anodes being on the substrate; a black pixel defining film having an opening exposing the first anode, an opening exposing the second anode, and an opening exposing the third anode; a cathode on the black pixel defining film, the first anode, the second anode, and the third anode; an encapsulation layer covering the cathode; a first insulating layer on the encapsulation layer and having a plurality of openings overlapping the opening exposing the second anode and the opening exposing the third anode in a plan view; and a second insulating layer on the first insulating layer, in the plurality of openings in the first insulating layer, and having a higher refractive index than the first insulating layer. The first insulating layer does not have an opening corresponding to the opening exposing the first anode.

The light emitting display device may further include an organic film between the substrate and the first anode, the second anode, and the third anode, and the organic film may have a halftone exposure area overlapping at least one of the first anode, the second anode, and the third anode in the plan view, and a step of the halftone exposure area may be 30 nm or less.

The halftone exposure area may overlap the first anode in the plan view, and the second anode and the third anode may not overlap the halftone exposure area in the plan view.

The light emitting display device may further include a second data conductive layer between the substrate and the organic film. The organic film may include a lower organic film and an upper organic film, the halftone exposure area at a portion overlapping the first anode in the plan view may be on the lower organic film, and the halftone exposure area may not be on the upper organic film.

The light emitting display device may further include a first data conductive layer between the substrate and the second data conductive layer. The first data conductive layer may have a first extension overlapping the first anode in a plan view, and the second data conductive layer may have a plurality of second extensions respectively overlapping the second anode and the third anode in the plan view.

The light emitting display device may further include: a light blocking member on the second insulating layer and having an opening; and a color filter filling the opening in the light blocking member.

A polarizer may not be on the light blocking member and the color filter.

The encapsulation layer may include a first inorganic encapsulation layer, an organic encapsulation layer, and a second inorganic encapsulation layer, and the first inorganic encapsulation layer may include a (1-1)-th inorganic encapsulation layer, a (1-2)-th inorganic encapsulation layer, and a (1-3)-th inorganic encapsulation layer that have different refractive indexes and thicknesses and that are sequentially stacked.

The refractive index of the (1-2)-th inorganic encapsulation layer may be the largest from among the layers of the first inorganic encapsulation layer, the refractive index of the (1-3)-th inorganic encapsulation layer may be the next largest, and the refractive index of the (1-1)-th inorganic encapsulation layer may be the smallest, and the (1-2)-th inorganic encapsulation layer may be the thickest from among the layers of the first inorganic encapsulation layer, the (1-1)-th inorganic encapsulation layer may be the next thickest, and the (1-3)-th inorganic encapsulation layer may be the thinnest.

The first inorganic encapsulation layer may further include a (1-4)-th inorganic encapsulation layer having a low refractive index and being on the (1-3)-th inorganic encapsulation layer.

According to embodiments of the present invention, flatness of an organic film positioned under an anode is improved so that the anode that reflects external light is flat, and by preventing reflected light from asymmetrically spreading, display quality is improved by reducing reflective color bands according to color spreading (color separation) caused by the reflected light. In addition, a ratio of external light being reflected is reduced by using a black pixel defining film that separates light emitting layers from each other instead of a polarizer.

In embodiments of the present invention, a lower surface of an anode in a green light emitting area is more planarized (e.g., is flatter) than a lower surface of an anode positioned in red and blue light emitting areas so that a reddish phenomenon in which a lot of red color generated at a low angle with respect to the front of a light emitting display device is displayed may be reduced or eliminated.

In embodiments of the present invention, an insulating layer lens having a difference in refractive index is formed in a front surface of red and blue light emitting areas so that light is transmitted to the front, and an insulating layer lens structure having a difference in refractive index is not formed in a front surface of a green light emitting area so that a reddish phenomenon in which a lot of red color generated at a low angle with respect to the front of a light emitting display device is displayed may be reduced or eliminated.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

FIG. 1 illustrates a schematic perspective view of a use state of a display device according to an embodiment.
FIG. 2 illustrates an exploded perspective view of a display device according to an embodiment.
FIG. 3 illustrates a block diagram of a display device according to an embodiment.
FIG. 4 illustrates a schematic perspective view of a light emitting display device according to an embodiment.
FIG. 5 illustrates an enlarged top plan view of a partial area of a light emitting display device according to an embodiment.
FIG. 6 illustrates a schematic circuit diagram of one pixel included in a light emitting display device according to an embodiment.
FIG. 7 to FIG. 21 illustrate structures of respective layers according to a manufacturing sequence of a lower panel layer of a light emitting display device according to an embodiment.
FIG. 22 illustrates a cross-sectional view of a light emitting display device according to an embodiment.
FIG. 23 illustrates a top plan view of a portion of an upper panel layer of a light emitting display device according to an embodiment.
FIG. 24 illustrates a step of planarizing an organic film of a light emitting display device by using a slit mask according to an embodiment.
FIG. 25 illustrates a graph of a planarization characteristic in a light emitting display device according to an embodiment.
FIG. 26 and FIG. 27 illustrate modified embodiments of FIG. 17 and FIG. 18.
FIG. 28 and FIG. 29 illustrate graphs of color coordinate values according to angles.
FIG. 30 and FIG. 31 respectively illustrate another modified embodiment.
FIG. 32 illustrates a schematic top plan view of a portion of a light emitting display device according to an embodiment.
FIG. 33 illustrates a cross-sectional view of a portion of the light emitting display device according to the embodiment shown in FIG. 32.
FIG. 34 illustrates a modified embodiment of the light emitting display device shown in FIG. 32.
FIG. 35 and FIG. 36 illustrate graphs of color coordinate values according to angles.
FIG. 37 illustrates a schematic cross-sectional view of an encapsulation layer according to an embodiment.
It is noted that FIGs. 1 to 25 essentially relate to embodiments according to a first aspect of the present invention, which does not form part of the appended claims. FIGs. 26 to 37 essentially relate to embodiments of the present invention, which does form part of the appended claims.

### DETAILED DESCRIPTION

The present invention will be described more fully hereinafter with reference to the accompanying drawings, in which embodiments of the present invention are shown.

To clearly describe the aspects and features of the present invention, parts, portions, and components of the embodiments that are irrelevant to the description or are well known in the relevant art may be omitted, and identical or similar constituent elements throughout the specification are denoted by the same reference numerals unless expressly described differently.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present invention relates to "one or more embodiments of the present invention." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present invention and is not intended to be limiting of the present invention. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

In addition, throughout the specification, "connected" does not only mean when two or more elements are directly connected but also means when two or more elements are indirectly connected through other elements and/or when they are physically connected or electrically connected, and further, it may be referred to by different names depending on a position or function, and may also be referred to as an embodiment in which respective parts that are substantially integrated are linked to each other.

In addition, throughout the specification, when an element, such as a wire, layer, film, region, area, substrate, plate, or constituent element, is described as "extended (or extends) in a first direction or second direction", this does not mean only a straight shape extending straight in the corresponding direction but may mean a structure that substantially extends in the first direction or the second direction, is partially bent, has a zigzag structure, or extends while having a curved structure or shape.

In addition, both an electronic device (for example, a mobile phone, a TV, a monitor, a laptop computer, etc.) including a display device, or a display panel described in the specification, and an electronic device including a display device and a display panel manufactured by a manufacturing method described in the specification are not excluded from the scope of the present specification.

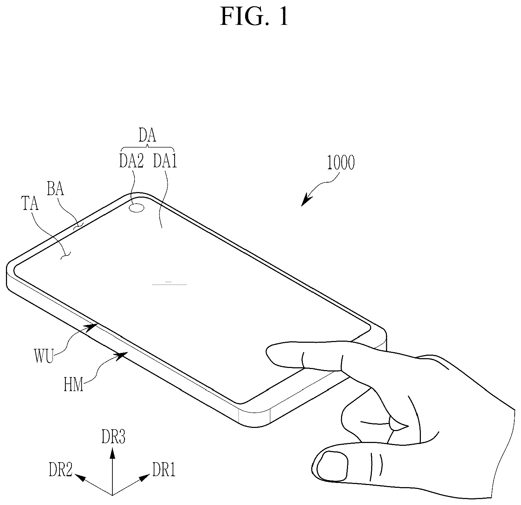

Hereinafter, a schematic structure of a light emitting display device will be described with reference to FIG. 1 to FIG. 3.

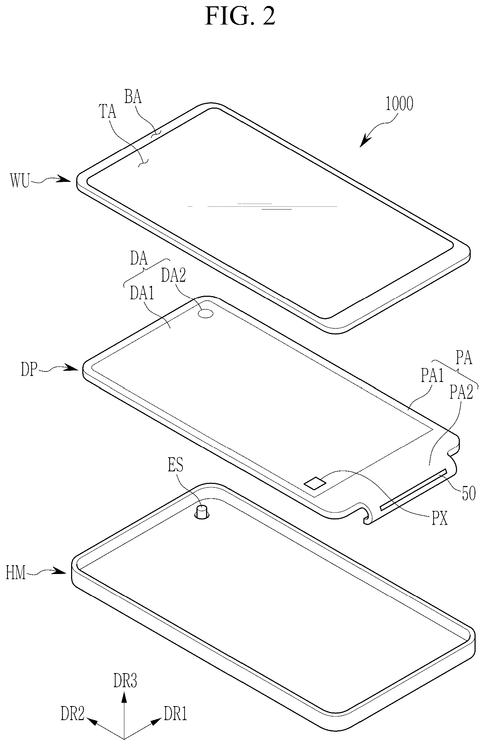

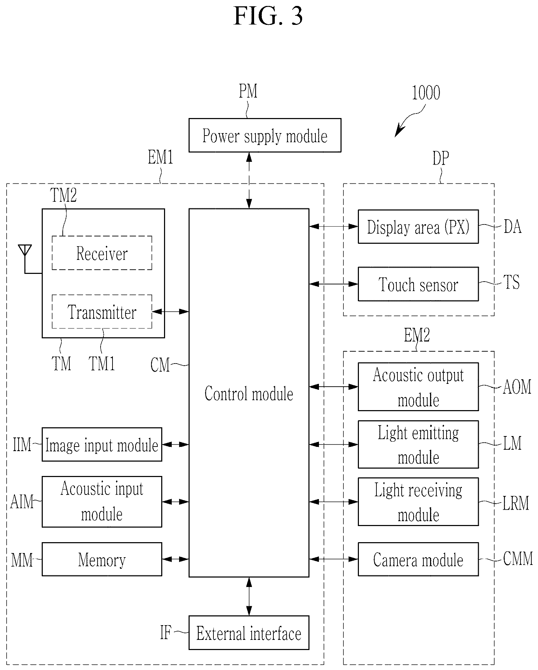

FIG. 1 illustrates a schematic perspective view of a use state of a display device according to an embodiment, FIG. 2 illustrates an exploded perspective view of a display device according to an embodiment, and FIG. 3 illustrates a block diagram of a display device according to an embodiment.

A light emitting display device 1000 according to an embodiment is a device for displaying a moving image and/or a still image. The light emitting display device 1000 may be used as a display screen of a portable electronic device, such as a mobile phone, a smart phone, a tablet personal computer (PC), a mobile communication terminal, an electronic note, an electronic book, a portable multimedia players (PMP), a navigation device, and an ultra-mobile PC (UMPC), or may be used as display screens of various products, such as a television set, a laptop computer, a monitor, a billboard, an Internet of things (IOT) device, etc. In addition, the light emitting display device 1000, according to an embodiment, may be used in a wearable device, such as a smart watch, a watch phone, a glasses display, and a head mounted display (HMD). In addition, the light emitting display device 1000, according to an embodiment, may be used as an instrument panel of a vehicle, a center information display (CID) disposed on a center fascia or dashboard of a vehicle, a room mirror display that replaces a side mirror of a vehicle, and a display disposed on the back of a front seat for entertainment for a rear seat of a vehicle. For better comprehension and ease of description, FIG. 1 illustrates an embodiment in which that the light emitting display device 1000 is used in (e.g., is installed in) a smart phone.

Referring to FIG. 1, FIG. 2, and FIG. 3, the light emitting display device 1000 may display an image toward (or in) a third direction DR3 on (or from) a display surface parallel to each of a first direction DR1 and a second direction DR2 (e.g., parallel to a plane defined by the first direction DR1 and the second direction DR2). A display surface, on which an image is displayed, may correspond to a front surface of the light emitting display device 1000 and may correspond to a front surface of a cover window WU. An image may include a static image as well as a dynamic (e.g., a moving or changing) image.

In the present embodiment, a front (or top) surface and a rear (or bottom) surface of each member are defined based on a direction in which an image is displayed. The front and rear surfaces may be opposite to each other in the third direction DR3, and a normal direction of each of the front and rear surfaces may be parallel to the third direction DR3. A separation distance in the third direction DR3 between the front and rear surfaces may correspond to a thickness of a light emitting display panel DP in the third direction DR3.

The light emitting display device 1000, according to an embodiment, may detect a user's input (see a hand shown in FIG. 1) applied from the outside. The user's input may include various types of external inputs, such as a part of the user's body, light, heat, or pressure. In FIG. 1, the user's input is shown to be the user's hand applied to the front surface. However, the present invention is not limited thereto. The user's input may be variously provided, and the light emitting display device 1000 may sense the user's input applied to the lateral or rear surface of the light emitting display device 1000 according to the structure of the light emitting display device 1000.

A display area DA may be largely (or primarily) divided into a first display area DA1 and a second display area DA2 (hereinafter also referred to as a component area), and in some embodiments, the second display area DA2 may include a light transmitting area and may also additionally include a pixel that displays an image. The second display area DA2 may at least partially overlap an optical element ES, such as a camera or an optical sensor. FIG. 1 shows an embodiment in which the second display area DA2 has a circle shape and is at an upper right side of the light emitting display device 1000, but the present invention is not limited thereto. The second display area DA2 may be provided in various numbers and shapes according to the number and shape of the optical elements ES.

The light emitting display device 1000 may receive an external signal for (e.g., to be received by) the optical element ES through the second display area DA2 or may provide a signal outputted from the optical element ES to the outside the second display area DA2. In an embodiment, the second display area DA2 is provided to overlap the light transmitting area so that an portion (or area) of a blocking area BA for forming the light transmitting area may be reduced. Herein, the blocking area BA is an area having relatively low light transmittance compared with a transmission area TA and may include a bezel area.

The light emitting display device 1000 may include the cover window WU, a housing HM, the light emitting display panel DP, and the optical element ES. In an embodiment, the cover window WU and the housing HM may be combined to form an appearance (e.g., an outer appearance) of the light emitting display device 1000.

The cover window WU may include an insulating panel. For example, the cover window WU may be made of glass, plastic, or a combination thereof.

A front surface of the cover window WU may define the front surface of the light emitting display device 1000. The transmission area TA may be an optically transparent area of the cover window WU. For example, the transmission area TA may be an area having visible ray (or light) transmittance of about 90% or more.

The blocking area BA may define a shape of the transmission area TA. The blocking area BA may be adjacent to the transmission area TA and may surround (e.g., may extend around a periphery of) the transmission area TA. The blocking area BA may be an area having relatively low light transmittance compared with the transmission area TA. The blocking area BA may include an opaque material that blocks light. The blocking area BA may have a color (e.g., a predetermined color). The blocking area BA may be defined by a bezel layer provided separately from a transparent substrate defining the transmission area TA or may be defined by an ink layer formed by being inserted into or coloring the transparent substrate.

The light emitting display panel DP may include a display panel DP for displaying an image, a touch sensor TS for sensing an external input, and a driver 50. The light emitting display panel DP may have a front surface that includes a display area DA and a non-display area PA. The display area DA may be an area in which a pixel operates to emit light according to an electrical signal.

In an embodiment, the display area DA may be an area that includes a pixel and at where an image is displayed and may be an area at where the touch sensor TS is positioned at an upper side of the pixel in the third direction DR3 to sense an external input.

The transmission area TA of the cover window WU may at least partially overlap the display area DA of the light emitting display panel DP. For example, the transmission area TA may overlap the front surface of the display area DA or may overlap at least a portion of the display area DA. Accordingly, a user may view an image through the transmission area TA or may provide an external input based on the image. However, the present invention is not limited thereto. For example, the display area DA may be divided into an area in which an image is displayed and an area in which an external input is sensed.

The non-display area PA of the light emitting display panel DP may at least partially overlap the blocking area BA of the cover window WU. The non-display area PA may be an area covered by the blocking area BA. The non-display area PA may be adjacent to the display area DA and may surround (e.g., may extend around a periphery of) the display area DA. No image is displayed in the non-display area PA, and a driving circuit or driving wire for driving the display area DA may be disposed therein. The non-display area PA may include a first peripheral area PA1 at an outer side of the display area DA and a second peripheral area PA2 including the driver 50, a connection wire, and a bending area. In the embodiment shown in FIG. 2, the first peripheral area PA1 is positioned at three sides of the display area DA, and the second peripheral area PA2 is positioned on the other side (e.g., the fourth side) of the display area DA.

In an embodiment, the light emitting display panel DP may be assembled in a flat state in which the display area DA and the non-display area PA are directed to the cover window WU. However, the present invention is not limited thereto. A portion of the non-display area PA of the light emitting display panel DP may be bent. In such an embodiment, a portion of the non-display area PA faces the rear surface of the light emitting display device 1000 so that a size of the blocking area BA shown on the front surface of the light emitting display device 1000 may be reduced, and as shown in FIG. 2, the second peripheral area PA2 is bent so that it may be assembled after disposing it on the rear surface of the display area DA.

The display area DA may include a first display area DA1 and a second display area DA2. The second display area DA2 includes the light transmitting area, and thus, it may have a relatively high light transmittance compared with the first display area DA1. In addition, the second display area DA2 may have a relatively smaller area than the first display area DA1. The second display area DA2 may be defined as an area overlapping an area of the light emitting display panel DP in which the optical element ES is disposed inside the housing HM. In the present embodiment, the second display area DA2 is illustrated as having a circular shape, but the present invention is not limited thereto. In other embodiments, the second display area DA2 may have various shapes, such as a polygon, an ellipse, and a shape with at least one curve.

The first display area DA1 may be adjacent to the second display area DA2. In an embodiment, the first display area DA1 may entirely surround (e.g., may extend around an entire periphery of) the second display area DA2. However, the present invention is not limited thereto. The first display area DA1 may partially surround (e.g., may extend a portion of the periphery of) the second display area DA2.

Referring to FIG. 3, the light emitting display panel DP may include the display area DA including a display pixel and the touch sensor TS. The light emitting display panel DP may be viewed by a user from the outside through the transmission area TA due to the pixel, which is a component that displays an image (e.g., that emits light to display an image). In addition, the touch sensor TS may be positioned on the pixel and may sense an external input applied from the outside. The touch sensor TS may sense an external input provided to the cover window WU.

Referring back to FIG. 2, the second peripheral area PA2 may include a bending portion. The display area DA and the first peripheral area PA1 may have a flat state substantially parallel to a plane defined by the first direction DR1 and the second direction DR2, and one side of the second peripheral area PA2 may extend from the flat state through the bending portion to have a flat state again (e.g., to have another flat portion). As a result, at least a portion of the second peripheral area PA2 may be bent to be assembled on the rear surface side of the display area DA. Because at least a portion of the second peripheral area PA2 overlaps the display area DA in a plan view when assembled, the size of the blocking area BA of the light emitting display device 1000 may be reduced. However, the present invention is not limited thereto. For example, in other embodiments, the second peripheral area PA2 may not be bent.

The driver 50 may be mounted on the second peripheral area PA2, mounted on the bending portion, or positioned at one of both sides of the bending portion. The driver 50 may be provided in a form of a chip.

The driver 50 may be electrically connected to the display area DA to transmit an electrical signal to the display area DA. For example, the driver 50 may provide data signals to pixels PX disposed in the display area DA. In some embodiments, the driver 50 may include a touch driving circuit and may be electrically connected to the touch sensor TS disposed in the display area DA. The driver 50 may include various circuits in addition to the above-described circuits or may be designed to provide various electrical signals to the display area DA.

A pad part may be positioned at an end of the second peripheral area PA2, and the light emitting display device 1000 may be electrically connected to a flexible printed circuit board (FPCB) including a driving chip by the pad part. Here, the driving chip positioned on the flexible printed circuit board may include various driving circuits for driving the light emitting display device 1000 or connectors for supplying power. In some embodiments, instead of the flexible printed circuit board, a rigid printed circuit board (PCB) may be used.

The optical element ES may be disposed under the light emitting display panel DP. The optical element ES may receive an external input transmitted through the second display area DA2 or may output a signal through the second display area DA2. In an embodiment, the second display area DA2 having relatively high transmittance is provided inside the display area DA so that the optical element ES may be disposed to overlap the display area DA, and accordingly, the area (or size) of the blocking area BA may be reduced.

Referring to FIG. 3, the light emitting display device 1000 may include the light emitting display panel DP, a power supply module PM, a first electronic module EM1, and a second electronic module EM2. The light emitting display panel DP, the power supply module PM, the first electronic module EM1, and the second electronic module EM2 may be electrically connected to each other. FIG. 3 shows an embodiment in which the display pixel and the touch sensor TS positioned in the display area DA of the light emitting display panel DP.

The power supply module PM may supply power for overall operation of the light emitting display device 1000. The power supply module PM may include a typical battery module.

The first electronic module EM1 and the second electronic module EM2 may include various functional modules for operating (e.g., for driving) the light emitting display device 1000. The first electronic module EM1 may be directly mounted on a motherboard electrically connected to the display panel DP or may be mounted on a separate substrate to be electrically connected to the motherboard through a connector.

The first electronic module EM1 may include a control module CM, a wireless communication module TM, an image input module IIM, an audio (or acoustic) input module AIM, a memory MM, and an external interface IF. Some of the modules are not mounted on the motherboard but may be electrically connected to the motherboard through the flexible printed circuit board connected thereto.

The control module CM may control the overall operation of the light emitting display device 1000. The control module CM may be a microprocessor. For example, the control module CM activates or deactivates the display panel DP. The control module CM may control other modules, such as the image input module IIM or the audio input module AIM, based on a touch signal received from the display panel DP.

The wireless communication module TM may transmit/receive a wireless signal with another terminal by using a Bluetooth^{®} or Wi-Fi protocol (e.g., via a suitable wireless communication protocol). The wireless communication module TM may transmit/receive a voice signal by using a general communication protocol. The wireless communication module TM includes a transmitter TM1 that modulates and transmits a signal and that transmits the same and a receiver TM2 that demodulates a received signal.

The image input module IIM may process an image signal to convert it into image data that may be displayed on the light emitting display panel DP. The audio input module AIM may receive an external audio signal inputted by a microphone in a recording mode, a voice recognition mode, etc. and convert it into electrical voice data.

The external interface IF may act as an interface connected to an external charger, a wired/wireless data port, a card socket (e.g., a memory card, a SIM/UIM card), and the like.

The second electronic module EM2 may include an audio (or acoustic) output module AOM, a light emitting module LM, a light receiving module LRM, and a camera module CMM, and at least some of these are optical elements ES and may be positioned on the rear surface of the display area DA as shown in, for example, FIG. 1 and FIG. 2. The optical element ES may include the light emitting module LM, the light receiving module LRM, and the camera module CMM. In addition, the second electronic module EM2 may be directly mounted on the motherboard, mounted on a separate substrate to be electrically connected to the light emitting display panel DP through a connector, or electrically connected to the first electronic module EM1.

The audio output module AOM may convert audio data received from the wireless communication module TM or audio data stored in the memory MM to output it to the outside.

The light emitting module LM may generate and output light. The light emitting module LM may output infrared rays (e.g., infrared light). For example, the light emitting module LM may include an LED element. For example, the light receiving module LRM may detect infrared rays (e.g., infrared light). The light receiving module LRM may be activated when infrared rays of a reference level (e.g., a predetermined level) or more are sensed (e.g., are received). The light receiving module LRM may include a CMOS sensor. After the infrared light generated by the light emitting module LM is outputted, it may be reflected by an external subject (e.g., by a user's finger or face), and the reflected infrared light may then be incident on the light receiving module LRM. The camera module CMM may capture an external image.

In an embodiment, the optical element ES may additionally include a light sensing sensor or a thermal sensing sensor. The optical element ES may sense an external object through (e.g., via signals received through) the front surface thereof or may provide a sound signal, such as a voice, through the front surface to the outside. In addition, the optical element ES may include a plurality of constituent elements and is not limited to any one embodiment.

Referring back to FIG. 2, the housing HM may be combined with the cover window WU. The cover window WU may be disposed on the front surface of the housing HM. The housing HM may be combined with the cover window WU to provide an accommodation space. The light emitting display panel DP and the optical element ES may be accommodated in the accommodation space provided between the housing HM and the cover window WU.

The housing HM may include a material with relatively high rigidity. For example, the housing HM may include a plurality of frames and/or plates made of glass, plastic, or metal, or a combination thereof. The housing HM may stably protect the components of the light emitting display device 1000 accommodated in the inner accommodation space from external impact.

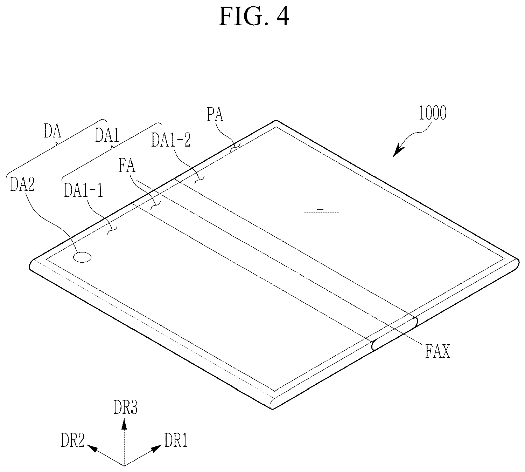

Hereinafter, a structure of a light emitting display device 1000 according to another embodiment will be described with reference to FIG. 4.

FIG. 4 illustrates a schematic perspective view of a light emitting display device according to another embodiment.

FIG. 4 illustrates a foldable light emitting display device 1000 which is designed to be folded at (or about) a folding line FAX.

In the foldable light emitting display device 1000, the second display area DA2 (hereinafter also referred to as a component area) may be positioned at the edge of one side thereof as shown in FIG. 4.

An optical element, such as a camera or an optical sensor, is positioned on the rear surface of the second display area DA2 shown in FIG. 4, and the light transmitting area is positioned in the second display area DA2. A structure of the light transmitting area may be described in more detail later.

Referring to FIG. 4, in the embodiment, the light emitting display device 1000 may be a foldable light emitting display device. The light emitting display device 1000 may be folded outwardly or inwardly based on the folding axis FAX. When the light emitting display device 1000 is folded outwardly based on the folding axis FAX, display surfaces thereof are each positioned at outer sides in the third direction DR3 so that images may be displayed in both directions. When the light emitting display device 1000 is folded inwardly based on the folding axis FAX, the display surfaces thereof may not be viewed from the outside.

The light emitting display device 1000 may include a housing, a light emitting display panel, and a cover window.

In an embodiment, the light emitting display panel may have the display area DA and the non-display area PA. The display area DA is an area at where an image is displayed and may be an area at where an external input is sensed. The display area DA may be an area at where a plurality of pixels, which will be described later, are disposed.

The display area DA may include a first display area DA1 and a second display area DA2. In addition, the first display area DA1 may be divided into a (1-1)-th display area DA1-1, a (1-2)-th display area DA1-2, and a folding area FA. The (1-1)-th display area DA1-1 and the (1-2)-th display area DA1-2 may be positioned at the left and right sides, respectively, based on the folding axis FAX (or with the folding axis FAX at the center), and the folding area FA may be positioned between the (1-1)-th display area DA1-1 and the (1-2)-th display area DA1-2. In such an embodiment, when folded outwardly based on the folding axis FAX, the (1-1)-th display area DA1-1 and the (1-2)-th display area DA1-2 are positioned at both sides in the third direction DR3, and an image may be displayed in both directions. In addition, when folded inwardly based on the folding axis FAX, the (1-1)-th display area DA1-1 and the (1-2)-th display area DA1-2 may not be viewed from the outside.

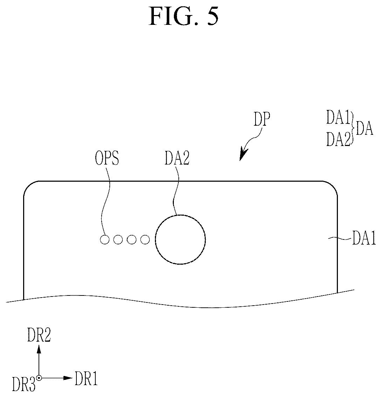

In some embodiments, the light emitting display panel DP may have an optical sensor area OPS (see, e.g., FIG. 5) in the first display area DA1 and adjacent to the second display area DA2.

FIG. 5 illustrates an enlarged top plan view of a partial area of the light emitting display device 1000 shown in FIG. 4 according to an embodiment.

FIG. 5 illustrates a portion of the light emitting display panel DP of the light emitting display device according to an embodiment in which the display panel is for (e.g., is included in) a mobile phone.

The light emitting display area DA is positioned in the front surface of the display panel DP, and the display area DA is largely divided into the first display area DA1 (hereinafter also referred to as a main display area) and the second display area DA2. Additionally, in the embodiment shown in FIG. 5, the photosensor area OPS is positioned in the first display area DA1 at a position adjacent to the second display area DA2. In the embodiment shown in FIG. 5, the photosensor area OPS is positioned to the left of the second display area DA2. However, the position and number of the optical sensor area OPS may vary according to embodiments.

A plurality of light emitting diodes, and a plurality of pixel circuits that generate and transmit a light emitting current to each of the plurality of light emitting diodes, are formed in the first display area DA1. Here, one light emitting diode and one pixel circuit are referred to as a pixel PX. The pixel circuits and the light emitting diodes are formed in a one-to-one ratio in the first display area DA1. The first display area DA1 is hereinafter also referred to as a 'normal display area'. Although only an upper portion of a structure of the light emitting display panel DP is shown in FIG. 5, the first display area DA1 may be extend below the cutting line as shown in, for example, FIG. 4.

In the optical sensor area OPS, only transparent layers are formed to allow light to pass therethrough and no conductive layer or semiconductor layer is positioned there. Further, an opening (hereinafter also referred to as an additional opening) is formed in a black pixel defining film 380, a light blocking member 220, and a color filter 230, to be described later, at a position corresponding to the optical sensor area OPS so that light is not blocked from passing therethrough.

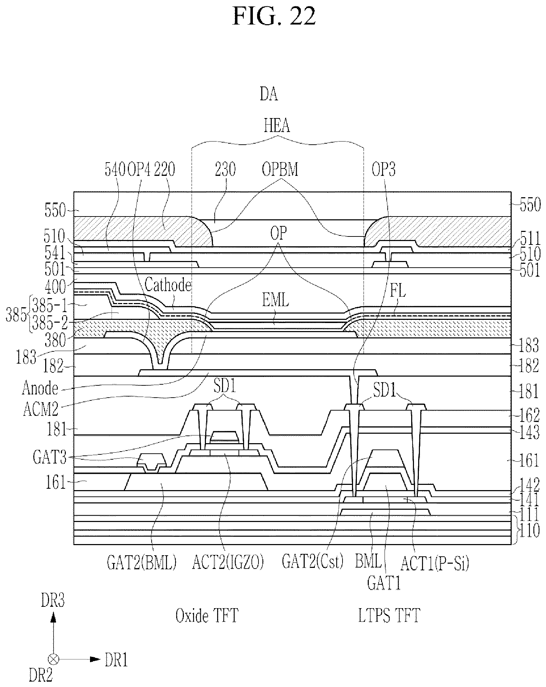

The light emitting display panel DP according to an embodiment may be primarily divided into a lower panel layer and an upper panel layer. The lower panel layer is a portion in which the light emitting diode and the pixel circuit part configuring the pixel are positioned and may include an encapsulation layer 400 (see, e.g., FIG. 22) covering it. For example, the lower panel layer is from a substrate 110 (see, e.g., FIG. 22) to the encapsulation layer 400, includes an anode (Anode), a black pixel defining film 380, a light emitting layer EML, a spacer 385, a functional layer FL, a cathode (Cathode), and includes an insulating film, a semiconductor layer, and a conductive layer between the substrate and the anode (see, e.g. FIG. 22). The upper panel layer is a portion positioned at an upper portion of the encapsulation layer, may include sensing insulating layers 501, 510, and 511 (see, e.g., FIG. 22) configured to sense a touch and a plurality of sensing electrodes 540 and 541 (see, e.g., FIG. 22), and may include a light blocking member 220, a color filter 230, and a planarization layer 550 (see, e.g., FIG. 22).

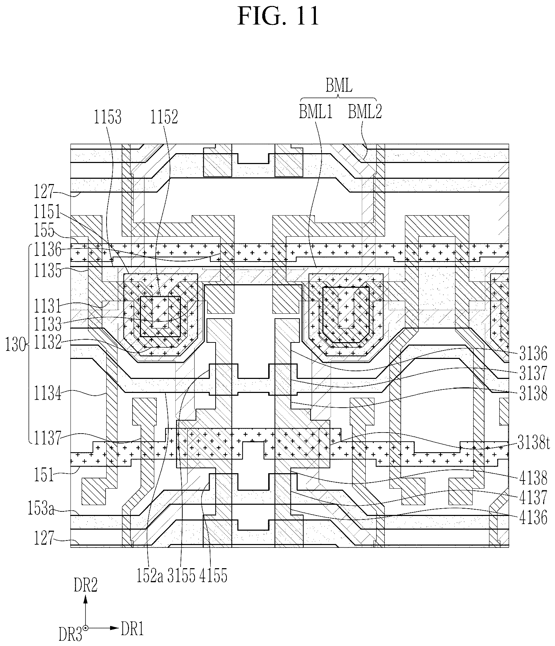

A structure of the lower panel layer of the first display area DA1 will be described in more detail with reference to FIG. 11 to FIG. 22.

A peripheral area may be positioned outside the display area DA. In addition, although FIG. 5 illustrates an embodiment in which the display panel is for a mobile phone, the present embodiment may be applied to any suitable device as long as it is a display panel in which the optical element may be positioned on the rear surface of the display panel, and it may be a flexible display device. In a case of a foldable display device from among the types of flexible display devices, positions of the second display area DA2 and the optical sensor area OPS may be different from those shown in FIG. 5.

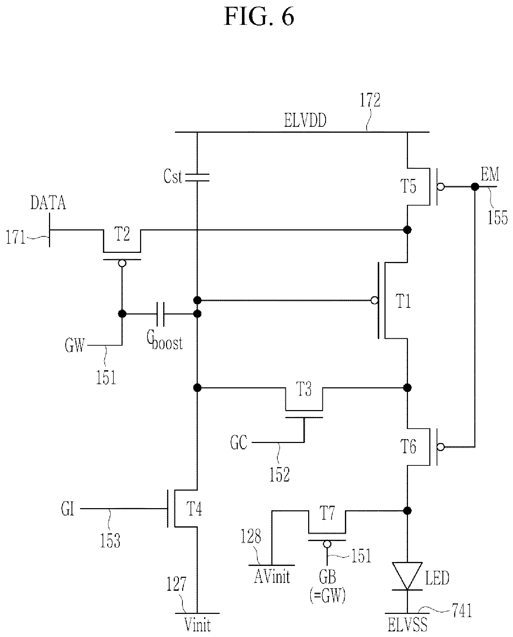

Hereinafter, a structure of the pixel positioned on the lower panel layer of the light emitting display panel DP will be described in detail with reference to FIG. 6 to FIG. 23.

The following pixel structure may be a pixel structure of the first display area DA1 and/or the second display area DA2 including the optical sensor area OPS.

First, a circuit structure of a pixel will be described with reference to FIG. 6.

FIG. 6 illustrates a schematic circuit diagram of one pixel included in a light emitting display device according to an embodiment.

The circuit structure shown in FIG. 6 is a circuit structure of a pixel circuit part and a light emitting diode formed in the first display area DA1 and the second display area DA2.

One pixel according to the embodiment includes transistors T1, T2, T3, T4, T5, T6, and T7, a storage capacitor Cst, a boost capacitor C_{boost}, and a light emitting diode LED connected to a plurality of wires 127, 128, 151, 152, 153, 155, 171, 172, and 741. Here, the transistors and the capacitors excluding the light emitting diode LED form a pixel circuit part. In some embodiments, the boost capacitor C_{boost} may be omitted.

The plurality of wires 127, 128, 151, 152, 153, 155, 171, 172, and 741 are connected to one pixel PX. The plurality of wires includes a first initialization voltage line 127, a second initialization voltage line 128, a first scan line 151, a second scan line 152, an initialization control line 153, a light emitting control line 155, a data line 171, a driving voltage line 172, and a common voltage line 741. The first scan line 151 connected to the seventh transistor T7 is also connected to the second transistor T2, but in some embodiments, the seventh transistor T7, unlike the second transistor T2, may be connected to a bypass control line.

The first scan line 151 is connected to a scan driver to transmit a first scan signal GW to the second transistor T2 and the seventh transistor T7. The second scan line 152 may be applied with a voltage of an opposite polarity to a voltage applied to the first scan line 151 at the same timing as that of a signal of the first scan line 151. For example, when a negative voltage is applied to the first scan line 151, a positive voltage may be applied to the second scan line 152. The second scan line 152 transmits a second scan signal GC to the third transistor T3. The initialization control line 153 transmits an initialization control signal GI to the fourth transistor T4. The light emitting control line 155 transmits a light emitting control signal EM to the fifth transistor T5 and the sixth transistor T6.

The data line 171 is a line that transmits a data voltage DATA generated by a data driver, and thus, as an amount of a light emitting current transmitted to the light emitting diode LED is changed, luminance of light emitted by the light emitting diode LED is accordingly changed. The driving voltage line 172 applies a driving voltage ELVDD. The first initialization voltage line 127 transmits a first initialization voltage Vinit, and the second initialization voltage line 128 transmits a second initialization voltage AVinit. The common voltage line 741 applies a common voltage ELVSS to a cathode of the light emitting diode LED. In the present embodiment, each of voltages applied to the driving voltage line 172, the first and second initialization voltage lines 127 and 128, and the common voltage line 741 may be a constant voltage.

The driving transistor T1 (also referred to as the first transistor) is a p-type transistor and has a silicon semiconductor as a semiconductor layer. The driving transistor T1 adjusts the amount of the emitting current outputted to the anode of the light emitting diode LED according to a voltage (e.g., a voltage stored in the storage capacitor Cst) of a gate electrode of the driving transistor T1. Because brightness of the light emitting diode LED is adjusted according to the amount of the light emitting current outputted to the anode electrode of the light emitting diode LED, light emitting luminance of the light emitting diode LED may be adjusted according to the data voltage DATA applied to the pixel. For this purpose, a first electrode of the driving transistor T1 is disposed to receive the driving voltage ELVDD and is connected to the driving voltage line 172 via the fifth transistor T5. In addition, the first electrode of the driving transistor T1 is connected to a second electrode of the second transistor T2 to receive the data voltage DATA. A second electrode of the driving transistor T1 outputs the light emitting current to the light emitting diode LED and is connected to the anode of the light emitting device LED via the sixth transistor T6 (hereinafter referred to as an output control transistor). In addition, the second electrode of the driving transistor T1 is also connected to the third transistor T3 to transmit the data voltage DATA applied to the first electrode thereof to the third transistor T3. A gate electrode of the driving transistor T1 is connected to one electrode of the storage capacitor Cst (hereinafter referred to as a 'second storage electrode'). Accordingly, a voltage of the gate electrode of the driving transistor T1 is changed according to a voltage stored in the storage capacitor Cst, and accordingly, a light emitting current outputted from the driving transistor T1 is changed. The storage capacitor Cst maintains the voltage of the gate electrode of the driving transistor T1 constant for one frame. The gate electrode of the driving transistor T1 may also be connected to the third transistor T3 so that the data voltage DATA applied to the first electrode of the driving transistor T1 passes through the third transistor T3 to be transmitted to the gate electrode of the driving transistor T1. The gate electrode of the driving transistor T1 may also be connected to the fourth transistor T4 to be initialized by receiving the first initialization voltage Vinit.

The second transistor T2 is a p-type transistor and has a silicon semiconductor as a semiconductor layer. The second transistor T2 is a transistor that allows the data voltage DATA to be received into the pixel. A gate electrode of the second transistor T2 is connected to the first scan line 151 and one electrode of the boost capacitor C_{boost} (hereinafter, referred to as a 'lower boost electrode'). A first electrode of the second transistor T2 is connected to the data line 171. A second electrode of the second transistor T2 is connected to the first electrode of the driving transistor T1. When the second transistor T2 is turned on by a negative voltage of the first scan signal GW transmitted through the first scan line 151, the data voltage DATA transmitted through the data line 171 is transmitted to the first electrode of the driving transistor T1, and finally, the data voltage DATA is transmitted to the gate electrode of the driving transistor T1 to be stored in the storage capacitor Cst.

The third transistor T3 is an n-type transistor and has an oxide semiconductor as a semiconductor layer. The third transistor T3 electrically connects the second electrode of the driving transistor T1 and the gate electrode of the driving transistor T1. As a result, the third transistor T3 allows the data voltage DATA to be compensated by a threshold voltage of the driving transistor T1 and then stored in the second storage electrode of the storage capacitor Cst. A gate electrode of the third transistor T3 is connected to the second scan line 152, and a first electrode of the third transistor T3 is connected to the second electrode of the driving transistor T1. A second electrode of the third transistor T3 is connected to the second storage electrode of the storage capacitor Cst, the gate electrode of the driving transistor T1, and the other electrode of the boost capacitor C_{boost} (hereinafter referred to as an 'upper boost electrode'). The third transistor T3 is turned on by a positive voltage of the second scan signal GC transmitted through the second scan line 152 to connect the gate electrode of the driving transistor T1 and the second electrode of the driving transistor T1 and to allow a voltage applied to the gate electrode of the driving transistor T1 to be transmitted to the second storage electrode of the storage capacitor Cst to be stored in the storage capacitor Cst. In such an embodiment, the voltage stored in the storage capacitor Cst is stored in a state in which the voltage of the gate electrode of the driving transistor T1 when the driving transistor T1 is turned off is stored and a threshold voltage (Vth) of the driving transistor T1 is compensated.

The fourth transistor T4 is an n-type transistor and has an oxide semiconductor as a semiconductor layer. The fourth transistor T4 initializes the gate electrode of the driving transistor T1 and the second storage electrode of the storage capacitor Cst. A gate electrode of the fourth transistor T4 is connected to the initialization control line 153, and a first electrode of the fourth transistor T4 is connected to the first initialization voltage line 127. A second electrode of the fourth transistor T4 is connected to the second electrode of the third transistor T3, the second storage electrode of the storage capacitor Cst, the gate electrode of the driving transistor T1, and the upper boost electrode of the boost capacitor C_{boost}. The fourth transistor T4 is turned on by a positive voltage of the initialization control signal GI received through the initialization control line 153, and when it is turned on, it transmits the first initialization voltage Vinit to the gate electrode of the driving transistor T1, to the second storage electrode of the storage capacitor Cst, and to the upper boost electrode of the boost capacitor C_{boost} to initialize them.

The fifth transistor T5 and the sixth transistor T6 are p-type transistors and have silicon semiconductors as a semiconductor layer.

The fifth transistor T5 transmits the driving voltage ELVDD to the driving transistor T1. A gate electrode of the fifth transistor T5 is connected to the light emitting control line 155, a first electrode of the fifth transistor T5 is connected to the driving voltage line 172, and a second electrode of the fifth transistor T5 is connected to the first electrode of the driving transistor T1.

The sixth transistor T6 transmits a light emitting current outputted from the driving transistor T1 to the light emitting diode LED. A gate electrode of the sixth transistor T6 is connected to the light emitting control line 155, a first electrode of the sixth transistor T6 is connected to the second electrode of the driving transistor T1, and a second electrode of the sixth transistor T6 is connected to the anode of the light emitting diode LED.

The seventh transistor T7 is a p-type or n-type transistor and has a silicon semiconductor or oxide semiconductor as a semiconductor layer. The seventh transistor T7 initializes the anode of the light emitting diode LED. A gate electrode of the seventh transistor T7 is connected to the first scan line 151, a first electrode of the seventh transistor T7 is connected to the anode of the light emitting diode LED, and a second electrode of the seventh transistor T7 is connected to the second initialization voltage line 128. When the seventh transistor T7 is turned on by a negative voltage of the first scan line 151, the second initialization voltage AVint is applied to the anode of the light emitting diode LED to initialize it. The gate electrode of the seventh transistor T7 may be connected to a separate bypass control line and may separately control it from the first scan line 151. In addition, in some embodiments, the second initialization voltage line 128 to which the second initialization voltage AVinit is applied may be the same as the first initialization voltage line 127 to which the first initialization voltage Vinit is applied.

Although an embodiment has been described in which one pixel PX includes the seven transistors T1 to T7 and two capacitors (the storage capacitor Cst and the boost capacitor C_{boost}), the present invention is not limited thereto. In some embodiments, the boost capacitor C_{boost} may be omitted. In addition, although the third transistor T3 and the fourth transistor T4 are described as being n-type transistors, only one of them may be an n-type transistor and the other thereof may be an n-type transistor. In addition, in some embodiments, all of the seven transistors T1 to T7 may be formed as p-type transistors.

In the above, the circuit structure of the pixel formed in the display area DA has been described with reference to FIG. 6.

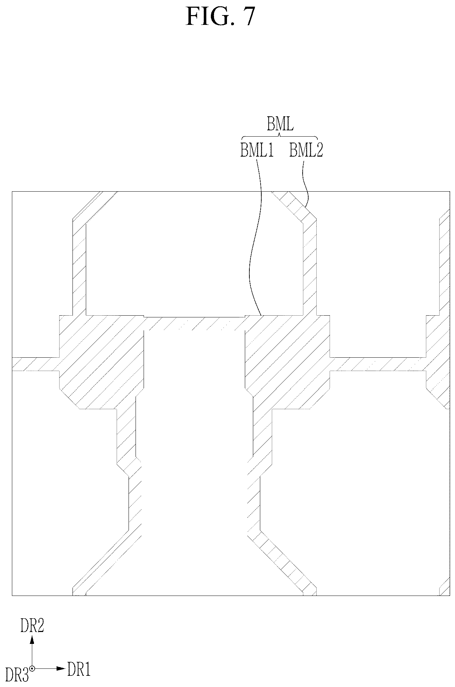

Hereinafter, a detailed planar structure and a stacked structure of the pixel formed in the display area DA will be described with reference to FIG. 7 to FIG. 22, where the described pixel includes the optical sensor area OPS. In addition, in the embodiment shown in FIG. 7 to FIG. 22, from among the red, green, and blue light emitting diodes LED, only a second organic film 182 positioned below the anode included in the green light emitting diode LED is further planarized by using a slit mask. Thus, a third organic film 183 positioned on the second organic film 182 may not undergo an additional planarization process by using a slit mask. Through such a planarization process, the anode included in the green light emitting diode LED is formed to be planarized (or more planarized). Because no polarizer is formed on the front surface of the light emitting display device according to the present embodiment, external light may be incident to the inside thereof to be reflected by the anode. The anode of the green light emitting diode LED, that is more flatly formed, may cause the green light component to be increased at a low angle, that is, before and after about 30 degrees based on the front (the third direction DR3). The anodes of the red and blue light emitting diodes LED, which have relatively low flatness (e.g., which are comparatively rougher), the component of the corresponding color may be increased at an angle greater than a low angle, that is, about 45 degrees or about 60 degrees based on the third direction DR3. As a result, a reddish phenomenon may be reduced by increasing the green component at a low angle (e.g., about 30 degrees based on the front (the third direction DR3)). Here, the light emitting diode LED may correspond to an opening OP in the pixel defining film (refer to 380) in a plan view and may be referred to as a light emitting area.

Hereinafter, a planar structure of each layer according to a manufacturing sequence will be described with reference to FIG. 7 to FIG. 21. The pixel structure shown herein may be a pixel structure of the first display area DA1 and/or the second display area DA2 including the optical sensor area OPS.

FIG. 7 to FIG. 21 illustrate structures of respective layers according to a manufacturing sequence (or process) of a lower panel layer of a light emitting display device according to an embodiment.

Referring to FIG. 7, a metal layer BML is positioned on (e.g., is formed on) a substrate 110.

The substrate 110 may include a material that has a rigid characteristic, such as glass, and thus, is not bent or bendable, or may include a flexible material, such as plastic or polyimide, that may be bent. In an embodiment including a flexible substrate, as shown in, for example, FIG. 22, the flexible substrate may have a two-layered structure that has polyimide and a barrier layer formed of an inorganic insulating material thereon as a double-layer structure.

The metal layer BML includes a plurality of extensions BML1 and a connecting portion BML2 for connecting the plurality of extensions BML1 to each other. The extension BML1 of the metal layer BML may be formed at a position overlapping a channel 1132 of a first semiconductor layer of the driving transistor T1 in a plan view, to be described later. The metal layer BML is also referred to as a lower shielding layer and may include a metal, such as copper (Cu), molybdenum (Mo), aluminum (Al), titanium (Ti), or a metal alloy thereof, may additionally include amorphous silicon, and may be formed as a single layer or a multilayer.

Referring to FIG. 22, a buffer layer 111 covering the substrate 110 and the metal layer BML is positioned thereon. The buffer layer 111 blocks penetration of impurity elements into a first semiconductor layer 130 and may be an inorganic insulating layer including a silicon oxide (SiOₓ), a silicon nitride (SiNₓ), or a silicon oxynitride (SiOₓN_{y}).

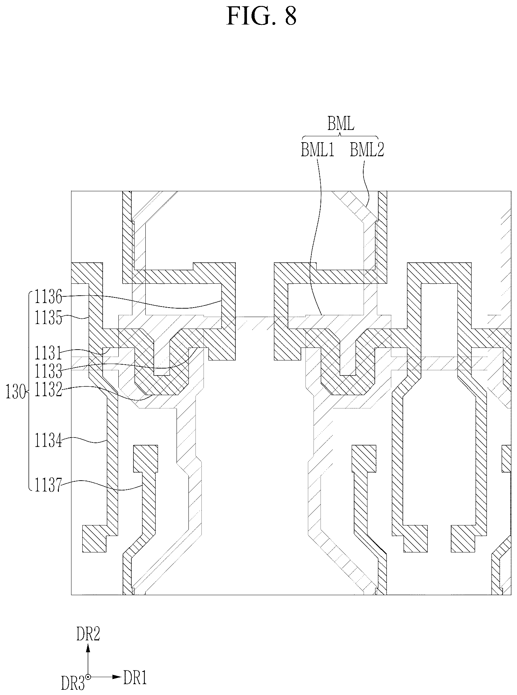

The first semiconductor layer 130 formed of a silicon semiconductor (e.g., a polycrystalline semiconductor) is positioned on the buffer layer 111, as shown in FIG. 8. The first semiconductor layer 130 includes a channel 1132, a first area 1131, and a second area 1133 of the driving transistor T1. In addition, the first semiconductor layer 130 includes not only the channel of the driving transistor T1 but also the channels of the second transistor T2, the fifth transistor T5, the sixth transistor T6, and the seventh transistor T7, and respective sides of each channel have areas having conductive layer characteristics formed by plasma treatment or doping to act as first electrodes and second electrodes.

The channel 1132 of the driving transistor T1 may have a curved shape in a plan view. However, the shape of the channel 1132 of the driving transistor T1 is not limited thereto and may be variously changed. For example, the channel 1132 of the driving transistor T1 may be bent in a different shape or may be formed in a rod (or straight) shape. The first area 1131 and the second area 1133 of the driving transistor T1 may be positioned at respective sides of the channel 1132 of the driving transistor T1. The first area 1131 and the second area 1133 positioned at the first semiconductor layer act as the first electrode and the second electrode of the driving transistor T1.

In the first semiconductor layer 130, the channel, the first area, and the second area of the second transistor T2 are positioned in a portion 1134 extending downwardly (in a plan view) from the first area 1131 of the driving transistor T1. The channel, the first area, and the second area of the fifth transistor T5 are positioned in a portion 1135 extending upwardly (in a plan view) from the first area 1131 of the driving transistor T1. The channel, the first area, and the second area of the sixth transistor T6 are positioned in a portion 1136 extending upwardly (in a plan view) from the second area 1133 of the driving transistor T1. The channel, the first area, and the second area of the seventh transistor T7 are positioned in a portion 1137 that is further extended while being bent from the portion 1136 of the first semiconductor layer 130.

Referring to FIG. 22, a first gate insulating film 141 may be positioned on the first semiconductor layer 130 including the channel 1132, the first area 1131, and the second area 1133 of the driving transistor T1. The first gate insulating film 141 may be an inorganic insulating film including a silicon oxide (SiOₓ), a silicon nitride (SiNₓ), or a silicon oxynitride (SiOₓN_{y}).

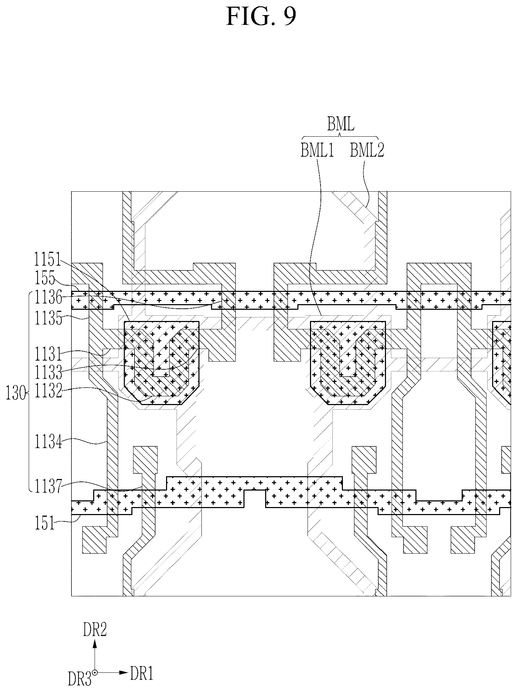

Referring to FIG. 9, a first gate conductive layer including a gate electrode 1151 of the driving transistor T1 may be positioned on the first gate insulating film 141. The first gate conductive layer may include a gate electrode of each of the second transistor T2, the fifth transistor T5, the sixth transistor T6, and the seventh transistor T7, as well as the driving transistor T1. The gate electrode 1151 of the driving transistor T1 may overlap the channel 1132 of the driving transistor T1. The channel 1132 of the driving transistor T1 is covered by the gate electrode 1151 of the driving transistor T1.

The first gate conductive layer may further include the first scan line 151 and the light emitting control line 155. The first scan line 151 and the light emitting control line 155 may substantially extend in a horizontal direction (hereinafter also referred to as the first direction DR1). The first scan line 151 may be connected to the gate electrode of the second transistor T2. The first scan line 151 may be integrated with (e.g., may be integral with) the gate electrode of the second transistor T2. The first scan line 151 is also connected to the gate electrode of the seventh transistor T7 of the adjacent pixel (e.g., of the rear pixel).

The light emitting control line 155 may be connected to the gate electrode of the fifth transistor T5 and the gate electrode of the sixth transistor T6, and the light emitting control line 155 and the gate electrodes of the fifth transistor T5 and the sixth transistor T6 may be integrally formed.

The first gate conductive layer may include a metal, such as copper (Cu), molybdenum (Mo), aluminum (Al), titanium (Ti), or a metal alloy thereof, and may be formed as a single layer or a multilayer.

After the first gate conductive layer including the gate electrode 1151 of the driving transistor T1 is formed, the exposed area of the first semiconductor layer 130 may be made conductive by performing a plasma treatment or a doping process. For example, the first semiconductor layer 130 covered by the first gate conductive layer is not conductive, and a portion of the first semiconductor layer 130 that is not covered by the first gate conductive layer may have the same characteristic as the conductive layer. As a result, the transistor including the conductive portion may have a p-type transistor characteristic so that the driving transistor T1, the second transistor T2, the fifth transistor T5, the sixth transistor T6, and the seventh transistor T7 may be p-type (or n-type) transistors.

Referring to FIG. 22, a second gate insulating film 142 may be positioned on the first semiconductor layer 130 and the first gate insulating film 141 including the gate electrode 1151 of the driving transistor T1. The second gate insulating film 142 may be an inorganic insulating film including a silicon oxide (SiOₓ), a silicon nitride (SiNₓ), or a silicon oxynitride (SiOₓN_{y}).

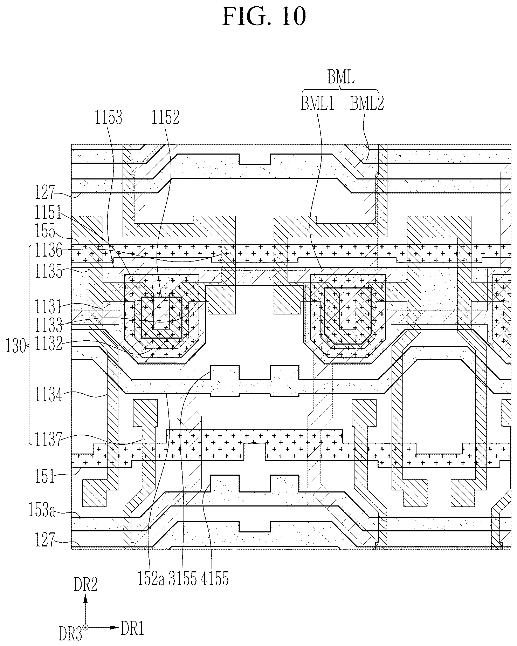

Referring to FIG. 10, a second gate conductive layer including a first storage electrode 1153 of the storage capacitor Cst, a lower shielding layer 3155 of the third transistor T3, and a lower shielding layer 4155 of the fourth transistor T4 may be positioned on the second gate insulating film 142. The lower shielding layers 3155 and 4155 may be positioned under the channels of the third transistor T3 and the fourth transistor T4, respectively, and may shield light or electromagnetic interference provided to the channels from lower sides thereof.

The first storage electrode 1153 overlaps the gate electrode 1151 of the driving transistor T1 to form the storage capacitor Cst. An opening 1152 is formed in the first storage electrode 1153 of the storage capacitor Cst. The opening 1152 in the first storage electrode 1153 of the storage capacitor Cst may overlap the gate electrode 1151 of the driving transistor T1. The first storage electrode 1153 extends in the horizontal direction (e.g., the first direction DR1) to be connected to the adjacent first storage electrode 1153.

The lower shielding layer 3155 of the third transistor T3 may overlap a channel 3137 and a gate electrode 3151 of the third transistor T3. The lower shielding layer 4155 of the fourth transistor T4 may overlap a channel 4137 and a gate electrode 4151 of the fourth transistor T4.

The second gate conductive layer may further include a lower second scan line 152a, a lower initialization control line 153a, and a first initialization voltage line 127. The lower second scan line 152a, the lower initialization control line 153a, and the first initialization voltage line 127 may substantially extend in the horizontal direction (e.g., the first direction DR1). The lower second scan line 152a may be connected to the lower shielding layer 3155 of the third transistor T3. The lower second scan line 152a may be integrally formed with the lower shielding layer 3155 of the third transistor T3. The lower initialization control line 153a may be connected to the lower shielding layer 4155 of the fourth transistor T4. The lower initialization control line 153a may be integrally formed with the lower shielding layer 4155 of the fourth transistor T4.

The second gate conductive layer GAT2 may include a metal, such as copper (Cu), molybdenum (Mo), aluminum (Al), titanium (Ti), or a metal alloy thereof, and may be formed as a single layer or a multilayer.

Referring to FIG. 22, a first interlayer insulating film 161 may be positioned on the second gate conductive layer including the first storage electrode 1153 of the storage capacitor Cst, the lower shielding layer 3155 of the third transistor T3, and the lower shielding layer 4155 of the fourth transistor T4. The first interlayer insulating film 161 may include an inorganic insulating film including a silicon oxide (SiOₓ), a silicon nitride (SiNₓ), or a silicon oxynitride (SiOₓN_{y}), and in some embodiments, the inorganic insulating material may be formed to be relatively thick (e.g., to be relatively thicker than other insulating films).

Referring to FIG. 11, an oxide semiconductor layer including a channel 3137, a first area 3136, and a second area 3138 of the third transistor T3, and a channel 4137, a first area 4136, and a second area 4138 of the fourth transistor T4 may be positioned on the first interlayer insulating film 161. In addition, the oxide semiconductor layer may include an upper boost electrode 3138t of the capacitor C_{boost}.

The channel 3137, the first area 3136, and the second area 3138 of the third transistor T3, and the channel 4137, the first area 4136, and the second area 4138 of the fourth transistor T4 may be connected to each other (e.g., may be integrally formed). The first area 3136 and the second area 3138 of the third transistor T3 are positioned at respective sides of the channel 3137 of the third transistor T3, and the first area 4136 and the second area 4138 of fourth transistor T4 are positioned at respective sides of the channel 4137 of the fourth transistor T4. The second area 3138 of the third transistor T3 is connected to the second area 4138 of the fourth transistor T4. The channel 3137 of the third transistor T3 overlaps the lower shielding layer 3155, and the channel 4137 of the fourth transistor T4 overlaps the lower shielding layer 4155.

The upper boost electrode 3138t of the capacitor C_{boost} is positioned between the second area 3138 of the third transistor T3 and the second area 4138 of the fourth transistor T4. The upper boost electrode 3138t of the boost capacitor C_{boost} overlaps a part of the first scan line 151 (the lower boost electrode of the boost capacitor C_{boost}) to form the boost capacitor C_{boost}.

Referring to FIG. 22, a third gate insulating film 143 may be positioned on the oxide semiconductor layer including the channel 3137, the first area 3136, and the second area 3138 of the third transistor T3, and the channel 4137, the first area 4136, and the second area 4138 of the fourth transistor T4, and the upper boost electrode 3138t of the boost capacitor C_{boost}.

The third gate insulating film 143 may be positioned on an entire surface of the oxide semiconductor layer and the first interlayer insulating film 161. Therefore, the third gate insulating film 143 may cover upper and lateral surfaces of the channel 3137, the first area 3136, and the second area 3138 of the third transistor T3, the channel 4137, the first area 4136, and the second area 4138 of the fourth transistor T4, and the upper boost electrode 3138t of the boost capacitor C_{boost}. However, the present embodiment is not limited thereto, and the third gate insulating film 143 may not be positioned on the entire surface of the oxide semiconductor layer and the first interlayer insulating film 161. For example, the third gate insulating film 143 may overlap the channel 3137 of the third transistor T3, and it may not overlap (e.g., it may expose or may be offset from) the first area 3136 and the second area 3138 thereof. In addition, the third gate insulating film 143 may overlap the channel 4137 of the fourth transistor T4, and it may not overlap the first area 4136 and the second area 4138 thereof.

The third gate insulating film 143 may include an inorganic insulating film including a silicon oxide (SiOₓ), a silicon nitride (SiNₓ), or a silicon oxynitride (SiOₓN_{y}).

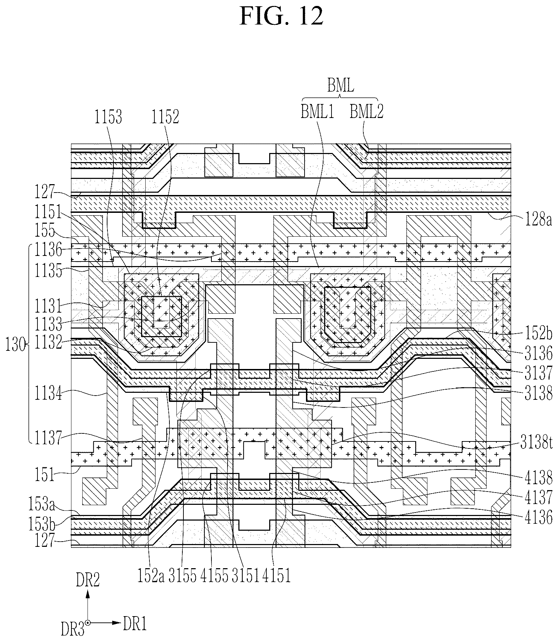

Referring to FIG. 12, a third gate conductive layer including the gate electrode 3151 of the third transistor T3 and the gate electrode 4151 of the fourth transistor T4 may be positioned on the third gate insulating film 143.

The gate electrode 3151 of the third transistor T3 may overlap the channel 3137 of the third transistor T3. The gate electrode 3151 of the third transistor T3 may overlap the lower shielding layer 3155 of the third transistor T3.

The gate electrode 4151 of the fourth transistor T4 may overlap the channel 4137 of the fourth transistor T4. The gate electrode 4151 of the fourth transistor T4 may overlap the lower shielding layer 4155 of the fourth transistor T4.

The third gate conductive layer may further include an upper second scan line 152b and an upper initialization control line 153b.

The upper second scan line 152b and the upper initialization control line 153b may substantially extend in the horizontal direction (e.g., the first direction DR1). The upper second scan line 152b forms the second scan line 152 together with the lower second scan line 152a. The upper second scan line 152b may be connected to the gate electrode 3151 of the third transistor T3. For example, the upper second scan line 152b may be integrally formed with the gate electrode 3151 of the third transistor T3. The upper initialization control line 153b forms the initialization control line 153 together with the lower initialization control line 153a. The upper initialization control line 153b may be connected to the gate electrode 4151 of the fourth transistor T4. For example, the upper initialization control line 153b may be integrally formed with the gate electrode 4151 of the fourth transistor T4.

In addition, the third gate conductive layer may further include a lower second initialization voltage line 128a. The lower second initialization voltage line 128a may substantially extend in the horizontal direction (e.g., the first direction DR1), and the second initialization voltage AVinit is applied thereto.

The third gate conductive layer GAT3 may include a metal, such as copper (Cu), molybdenum (Mo), aluminum (Al), titanium (Ti), or a metal alloy thereof, and may be formed as a single layer or a multilayer.

After the third gate conductive layer including the gate electrode 3151 of the third transistor T3 and the gate electrode 4151 of the fourth transistor T4 is formed through a plasma treatment or doping process, a portion of the oxide semiconductor layer that is covered by the third gate conductive layer is formed as a channel and a portion of the oxide semiconductor layer that is not covered by the third gate conductive layer is conductive. The channel 3137 of the third transistor T3 may be positioned under the gate electrode 3151 to overlap the gate electrode 3151. The first area 3136 and the second area 3138 of the third transistor T3 may not overlap the gate electrode 3151. The channel 4137 of the fourth transistor T4 may be positioned under the gate electrode 4151 to overlap the gate electrode 4151. The first area 4136 and the second area 4138 of the fourth transistor T4 may not overlap the gate electrode 4151. The upper boost electrode 3138t may not overlap the third gate conductive layer. A transistor including an oxide semiconductor layer may have characteristics of an n-type transistor.

Referring to FIG. 22, a second interlayer insulating film 162 may be positioned on the third gate conductive layer including the gate electrode 3151 of the third transistor T3 and the gate electrode 4151 of the fourth transistor T4. The second interlayer insulating film 162 may have a single layer or multi-layer structure. The second interlayer insulating film 162 may include an inorganic insulating material, such as a silicon nitride (SiOₓ), a silicon nitride (SiNₓ), or a silicon oxynitride (SiOₓN_{y}), and in some embodiments, it may include an organic material.

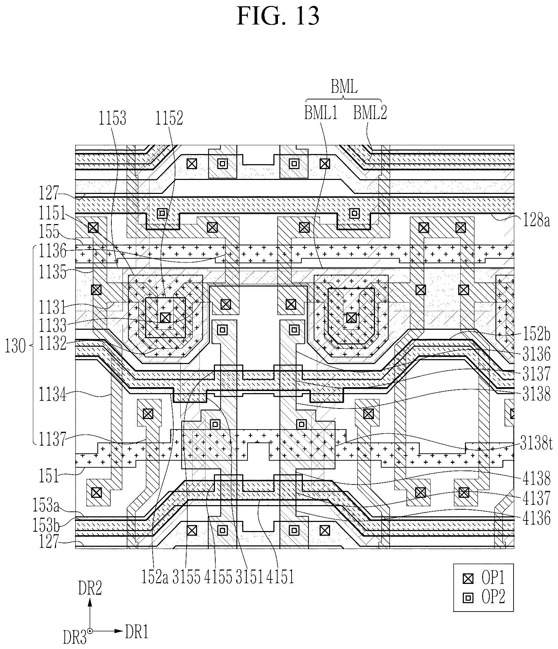

Referring to FIG. 13, two types of openings OP1 and OP2 may be formed in the second interlayer insulating film 162. The two types of openings OP1 and OP2 may be formed by using different masks.

The opening OP1 is formed in at least one of the second interlayer insulating film 162, the third gate insulating film 143, the first interlayer insulating film 161, the second gate insulating film 142, and the first gate insulating film 141, and it may expose the first semiconductor layer 130, the first gate conductive layer, or the second gate conductive layer.

The opening OP2 is formed in the second interlayer insulating film 162 and/or the third gate insulating film 143 and may expose the oxide semiconductor layer or the third gate conductive layer.

One of the openings OP1 overlaps at least a portion of the gate electrode 1151 of the driving transistor T1 and may also be formed in the third gate insulating film 143, the first interlayer insulating film 161, and the second gate insulating film 142. In such an embodiment, one of the openings OP1 may overlap the opening 1152 in the first storage electrode 1153 and may be positioned inside the opening 1152 in the first storage electrode 1153.

One of the openings OP2 may overlap at least a portion of the boost capacitor C_{boost} and may be further formed in the third gate insulating film 143.

Another one of the openings OP1 overlaps at least a portion of the second area 1133 of the driving transistor T1, and the third opening 3165 may be formed in the third gate insulating film 143, the first interlayer insulating film 161, the second gate insulating film 142, and the first gate insulating film 141.

Another one of the openings OP2 overlaps at least a portion of the first area 3136 of the third transistor T3 and may be formed in the third gate insulating film 143.

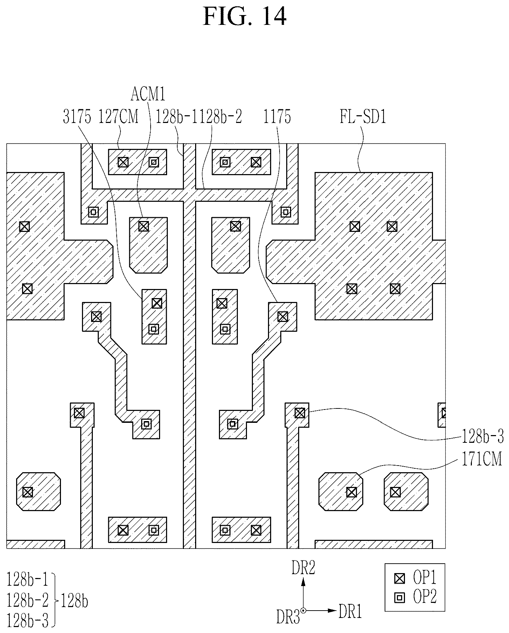

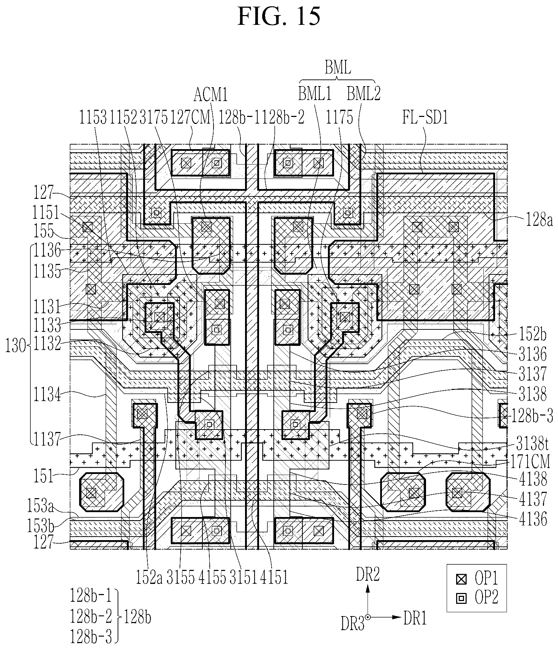

Referring to FIG. 14 and FIG. 15, a first data conductive layer including a first connection electrode 1175 and a second connection electrode 3175 may be positioned on the second interlayer insulating film 162. FIG. 14 is a top plan view showing only the first data conductive layer and the openings OP1 and OP2 shown in FIG. 15 because it may be difficult to easily recognize the first data conductive layer in FIG. 15, and FIG. 15 is a top plan view showing all layers below the first data conductive layer.

The first connection electrode 1175 may overlap the gate electrode 1151 of the driving transistor T1. The first connection electrode 1175 may be connected to the gate electrode 1151 of the driving transistor T1 through the openings OP1 and the opening 1152 of the first storage electrode 1153. The first connection electrode 1175 may overlap the boost capacitor C_{boost}. The first connection electrode 1175 may be connected to the upper boost electrode 3138t of the boost capacitor C_{boost} through the opening OP2. Accordingly, the gate electrode 1151 of the driving transistor T1 and the upper boost electrode 3138t of the boost capacitor C_{boost} may be connected by the first connection electrode 1175. In such an embodiment, the gate electrode 1151 of the driving transistor T1 may be connected to the second area 3138 of the third transistor T3 and the second area 4138 of the fourth transistor T4 by the first connection electrode 1175.

The second connection electrode 3175 may overlap the second area 1133 of the driving transistor T1. The second connection electrode 3175 may be connected to the second area 1133 of the driving transistor T1 through the opening OP1. The second connection electrode 3175 may overlap the first area 3136 of the third transistor T3. The second connection electrode 3175 may be connected to the first area 3136 of the third transistor T3 through the opening OP2. Accordingly, the second area 1133 of the driving transistor T1 and the first area 3136 of the third transistor T3 may be connected by the second connection electrode 3175.

The first data conductive layer may further include the second initialization voltage line 128b. The second initialization voltage line 128 includes a wire portion 128b-1 extending in a vertical direction (e.g., the second direction DR2), a first extension 128b-2 protruding from both sides of the wire portion 128b-1 in the horizontal direction (e.g., the first direction DR1), and a second extension 128b-3 positioned while being again bent from the first extension portion 128b-2 in the vertical direction (e.g., the second direction DR2). At a point where the first extension 128b-2 and the second extension 128b-3 meet, they are electrically connected to the second initialization voltage line 128a positioned on the third gate conductive layer through the opening OP2. As a result, the second initialization voltage AVinit is transmitted in the horizontal direction (e.g., the first direction DR1) through the second initialization voltage line 128a positioned on the third gate conductive layer and is transmitted in the vertical direction (e.g., the second direction DR2) through the second initialization voltage line 128b positioned on the first data conductive layer.

An end of the second extension 128b-3 is electrically connected to the portion 1137 of the first semiconductor layer 130 through the opening OP1.

The first data conductive layer may further include connecting portions 127CM and 171CM, an anode connecting member ACM1, and an extension FL-SD1 (hereinafter also referred to as a first extension).

The connecting portion 127CM is connected to the first initialization voltage line 127 of the second gate conductive layer through the opening OP1 and is connected to the first area 4136 of the second semiconductor layer (e.g., an oxide semiconductor layer) through the opening OP2 so that the first initialization voltage Vinit flowing through the first initialization voltage line 127 is transmitted to the fourth transistor T4 of the oxide semiconductor layer.

The connecting portion 171CM is electrically connected to the portion 1137 of the first semiconductor layer 130, that is, the second transistor T2, through the opening OP1.

The anode connecting member ACM1 is electrically connected to the portion 1136 of the first semiconductor layer 130, that is, the sixth transistor T6, through the opening OP1.

The extension FL-SD1 is formed to be relatively wide (e.g., relatively wider than the other extensions) to planarize the anode positioned thereon. The extension FL-SD1 may be at a position overlapping the anode included in the green light emitting diode LED in a plan view. In addition, the extension FL-SD1 is connected to the portion 1135 of the first semiconductor layer 130, that is, the fifth transistor T5, through the opening OP1, and is also electrically connected to the first storage electrode 1153 through the opening OP1.

The first data conductive layer SD1 may include a metal, such as aluminum (Al), copper (Cu), molybdenum (Mo), titanium (Ti), or a metal alloy thereof, and may be formed as a single layer or a multilayer.

Referring to FIG. 22, the first organic film 181 may be positioned on the first data conductive layer including the first connection electrode 1175 and the second connection electrode 3175. The first organic film 181 may be an organic insulating film including an organic material, and the organic material may include one or more of a polyimide, a polyamide, an acryl resin, benzocyclobutene, and a phenol resin.

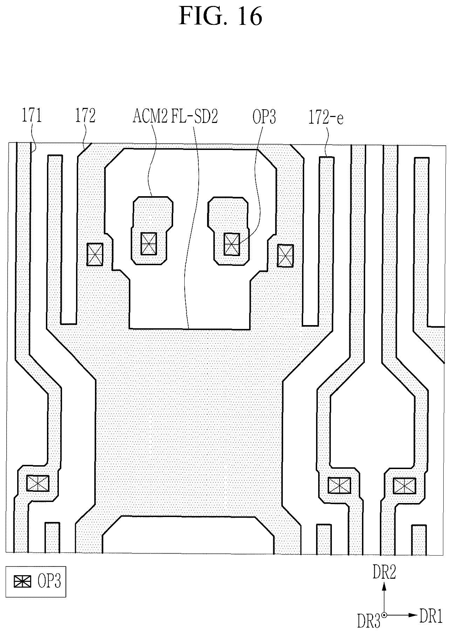

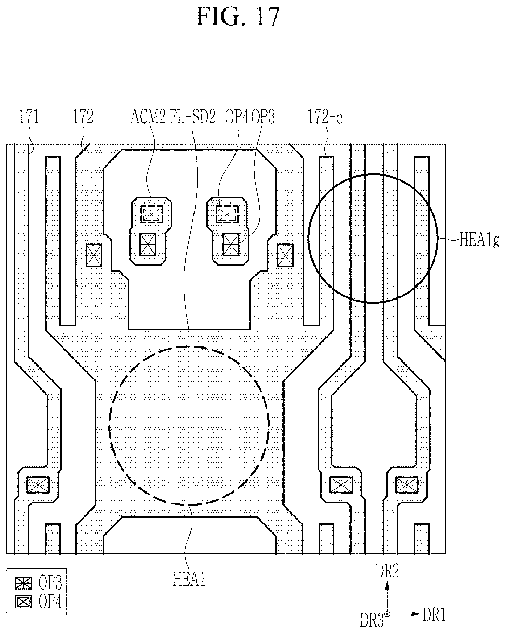

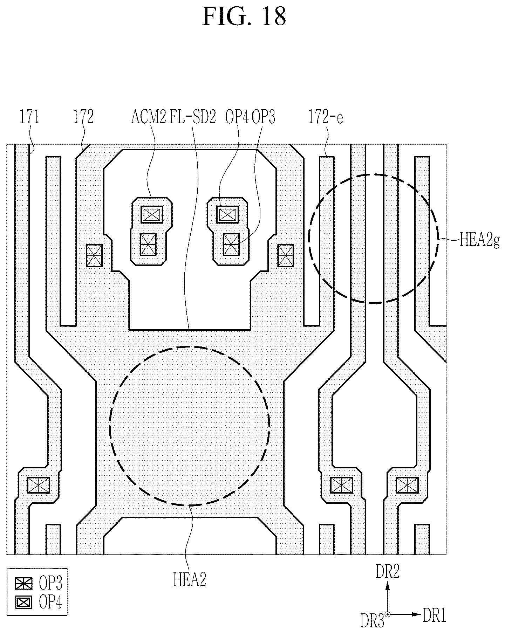

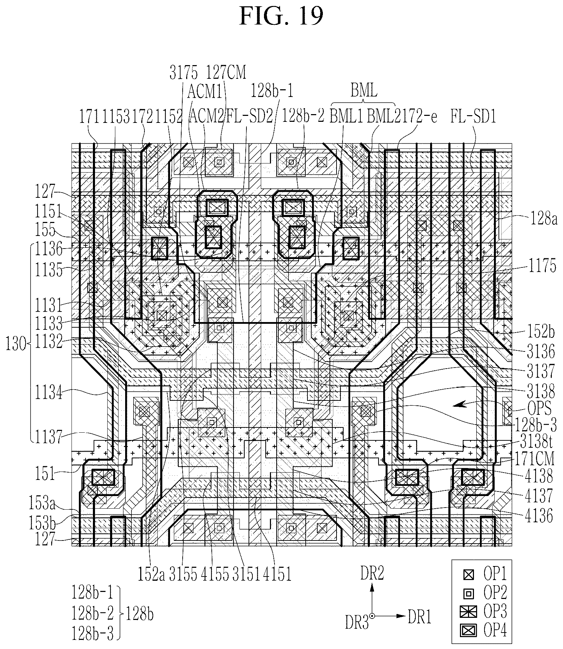

Referring to FIG. 16 to FIG. 19 and FIG. 22, an opening OP3 is formed in the first organic film 181. The second data conductive layer including the data line 171, the driving voltage line 172, and the anode connecting member ACM2 may be positioned on the first organic film 181. The second organic film 182 (hereinafter referred to as a lower organic film) and the third organic film 183 (hereinafter referred to as an upper organic film) are positioned on the second data conductive layer, and an opening OP4 (hereinafter also referred to as an opening for anode connection) is formed in the second organic film 182 and the third organic film 183. The anode connecting member ACM2 is electrically connected to the anode through the opening OP4. FIG. 16 to FIG. 18 are top plan views showing only the second data conductive layer and the openings OP3 and OP4 shown in FIG. 19 because it may be difficult to easily recognize the second data conductive layer in FIG. 19, and FIG. 19 is a top plan view showing the second data conductive layer and all layers therearound. More specifically, FIG. 16 illustrates only the second data conductive layer and the opening OP3, FIG. 17 illustrates an exposure process (or step) that forms the second organic film 182 shown in FIG. 16 and reduces an exposure amount of a partial area of the second organic film 182 by using a slit mask to planarize it, and FIG. 18 illustrates that the third organic film 183 is formed on the structure shown in FIG. 17 and no additional planarization is performed by not using a slit mask on the third organic film 183. FIG. 17 and FIG. 18 also illustrate the opening OP4 exposing the second data conductive layer on the second organic film 182 and the third organic film 183 by using a slit mask. The opening OP4 positioned on the second organic film 182 and the third organic film 183 may not overlap a planarized halftone exposure area in a plan view by reducing an exposure amount of a partial area by using the slit mask.

Referring to FIG. 15, FIG. 16, and FIG. 19, the opening OP3 in the first organic film 181 overlaps the connecting portion 171CM, the anode connecting member ACM1, and the extension FL-SD1 positioned on the first data conductive layer to respectively expose them.

The second data conductive layer formed on the first organic film 181 may include the data line 171, the driving voltage line 172, and the anode connecting member ACM2 and may be connected to the first data conductive layer through the opening OP3 in the first organic film 181.

The data line 171 and the driving voltage line 172 may substantially extend in the vertical direction (e.g., the second direction DR2). The data line 171 is connected to the connecting portion 171CM of the first data conductive layer through the opening OP3 and is connected to the second transistor T2 therethrough. The driving voltage line 172 is electrically connected to the fifth transistor T5 and the first storage electrode 1153 through the extension FL-SD1 of the first data conductive layer through the opening OP3. The anode connecting member ACM2 is electrically connected to the anode connecting member ACM1 of the first data conductive layer through the opening OP3 and is electrically connected to the sixth transistor T6.

Referring to FIG. 16, the driving voltage line 172 further includes an extension FL-SD2 (hereinafter referred to as a second extension) and a protruding wire portion 172-e and has a structure that is not formed at an area where the anode connecting member ACM2 is formed. The extension FL-SD2 may be at a position overlapping the anode included in the red and blue light emitting diodes LED in a plan view. The extension FL-SD2 is formed to be relatively wide to planarize the anode positioned thereon.

Two protruding wire portions 172-e of the driving voltage line 172 are also formed at both sides of the two data lines 171 to planarize the anode positioned thereon so that a total of four wires 171 and 172-e are positioned below the anode.

The anode has planarization characteristics due to the structure (e.g., the extension FL-SD1 and the wire portion 128b-1 of the first data conductive layer, and the extension FL-SD2 of the second data conductive layer, the data line 171, and the wire portion 172-e) below the anode as described above and the organic films 181, 182, and 183.

In the present embodiment, the extension FL-SD1 and the extension FL-SD2 are electrically connected to the driving voltage line 172 to receive the driving voltage ELVDD.

The second data conductive layer SD2 may include a metal, such as aluminum (Al), copper (Cu), molybdenum (Mo), titanium (Ti), or a metal alloy thereof, and may be formed as a single layer or a multilayer.

Referring to FIG. 22, the second organic film 182 and the third organic film 183 are positioned on the second data conductive layer. In the present embodiment, two organic films 182 and 183 are formed on the second data conductive layer to planarize the anode.

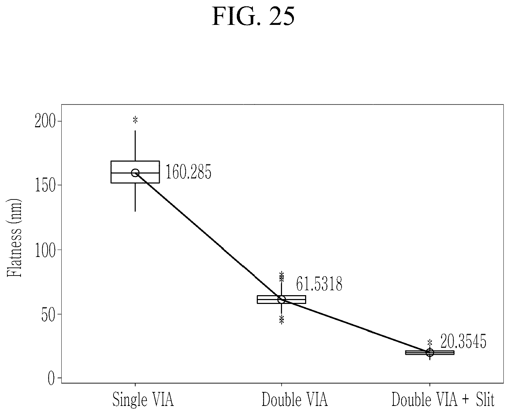

However, even if the two organic films 182 and 183 are formed thereon, a completely planarized structure is not obtained due to the conductive layer positioned thereunder (e.g., the first data conductive layer or the second data conductive layer). Referring to FIG. 25, in an embodiment including two organic films (referred to as double VIA), the flatness, that is, the height difference between the high and low points of the upper surface is at least about 50 nm. Therefore, in an embodiment including two organic films but not forming a halftone exposure area (double VIA), the step has a value exceeding about 30 nm. However, to prevent reflective color bands due to asymmetrical reflection of external light, the flatness needs to be further lowered (or improved), and it may be made to have a step or flatness of about 30 nm or less (see, e.g., FIG. 25).

In the present embodiment, the halftone exposure area may be formed by reducing an amount of exposure in a partial area of at least one of the two organic films 182 and 183. Here, the halftone exposure area is positioned in an area overlapping the opening OP in the black pixel defining film 380 or the anode in a plan view, and the halftone exposure area may be formed in an area wider than the opening OP in the black pixel defining film 380 or the anode (Anode).

In the following embodiment, from among the red, green, and blue light emitting diodes LED, only a second organic film 182 positioned below the anode included in the green light emitting diode LED is further planarized by using a slit mask.

The anode included in the green light emitting diode LED overlaps the extension FL-SD1 positioned on the first data conductive layer in a plan view so that the flatness thereof may be lower than that of the anode of the red and blue light emitting diodes LED overlapping the extension FL-SD2 positioned in the second data conductive layer in a plan view, thereby additionally performing the planarization process of the second organic film 182.

In addition, in the anode of the green light emitting diode LED that is more flatly formed, due to reflection of external light, the green light component may be increased at a low angle, that is, before and after about 30 degrees based on the front (e.g., the third direction DR3). On the other hand, in the anodes of the red and blue light emitting diodes LED with relatively low flatness (e.g., with a rougher surface), the component of the corresponding color may be increased at an angle greater than a low angle, that is, around 45 degrees or around 60 degrees based on the front (e.g., the third direction DR3). As a result, the reddish phenomenon may be reduced by increasing the green component at a low angle (e.g., about 30 degrees based on the front (the third direction DR3)).

The halftone exposure area according to an embodiment is shown in FIG. 17 and FIG. 18. In FIG. 17 and FIG. 18, an area HEA1g indicated by a solid line indicates a halftone exposure area, and an area indicated by dotted lines HEA1, HEA2, and HEA2g indicates an area that is not exposed as a halftone and is not subjected to an additional planarization process.

First, in FIG. 17, the first halftone exposure area HEA1g formed on the second organic film 182 on the upper portion of the second data conductive layer is shown, and a portion of the second organic film 182 overlapping the anode of the green light emitting diode LED is additionally planarized. However, a portion overlapping the anodes of the red and blue light emitting diodes LED, that is, the dotted line area HEA1 on the extension FL-SD2, is not additionally planarized.

In FIG. 18, it is formed on the third organic film 183 positioned on the second organic film 182, and a portion of the third organic film 183 overlapping the anodes of all color light emitting diodes LED is not exposed with a halftone to not be additionally planarized. Through this process, the anode of the green light emitting diode LED positioned on the upper portion of the third organic film 183 may have a step or flatness value of about 30 nm or less (see, e.g., FIG. 25).

Referring to FIG. 17, FIG. 22, and FIG. 24, after stacking the second organic film 182 on the upper portion of the second data conductive layer, the first halftone exposure area HEA1g is formed by exposing a partial area thereof with a reduced exposure amount by using a slit mask. Here, the first halftone exposure area HEA1g may correspond to a position at which the opening OP and the anode of the black pixel defining film 380 of the green light emitting diode LED are formed in a subsequent process to overlap all of the openings OP in the black pixel defining film 380 in a plan view and may overlap at least a portion of the anode (Anode) in a plan view. In such an embodiment, no additional planarization process may be performed because no halftone exposure area is formed in a portion where the openings OP in the black pixel defining film 380 of the red and blue light emitting diodes and the anode (Anode) are positioned.

Referring to FIG. 17, the first green halftone exposure area HEA1g and the opening OP of the black pixel defining film 380 of the green light emitting diode LED and the anode (Anode) overlap the data line 171 of the second data conductive layer and the wire portion 172-e, and overlap a total of four wires. In addition, the first green halftone exposure area HEA1g and the opening OP of the black pixel defining film 380 of the green light emitting diode LED and the anode (Anode) overlap the extension FL-SD1 of the first data conductive layer positioned on the first conductive layer in a plan view.

The second organic film 182 may be an organic insulating film and may include one or more of a polyimide, a polyamide, an acryl resin, benzocyclobutene, and a phenol resin. The second organic film 182 may be formed to have a thickness of about 1.5 µm and may have a value of greater than about 1 µm and smaller than about 2 µm. When the thickness of the second organic film 182 is about 1 µm, the planarization characteristic may not be good even if two organic films are formed to each have about a 1 µm thickness. When each of the thicknesses of the two organic films is about 2 µm or more, the flatness thereof is improved, but the flatness may be lowered (or reduced) as the thickness of the organic film is reduced due to an outgas phenomenon in which gas leaks during a cure process.

In addition, referring to FIG. 17, the opening OP4 exposing the second data conductive layer is positioned in the second organic film 182. In FIG. 17, the opening OP4 exposing the second data conductive layer is indicated by a dotted line, indicating that the opening OP4 is not completed. That is, because the opening OP4 is additionally formed in the third organic film 183 in a subsequent process, the opening OP4 is completed and the second data conductive layer is exposed. This will be described in more detail with reference to FIG. 18.

Referring to FIG. 18 and FIG. 22, the third organic film 183 is stacked on the second organic film 182. In FIG. 18, the areas HEA2 and HEA2g not subjected to a planarization process are indicated by dotted lines, and an additional planarization process is not performed because a slit mask is not used on the third organic film 183.

The third organic film 183 may be an organic insulating film and may include one or more of a polyimide, a polyamide, an acryl resin, benzocyclobutene, and a phenol resin. The third organic film 183 may be formed to have a thickness of about 1.5 µm but may have a value of greater than about 1 µm and smaller than about 2 µm. When the thickness of the third organic film 183 is about 1 µm, even if the two organic films 182 and 183 are formed to each have a thickness of about 1 µm, the planarization characteristic may not be good. However, when each of the thicknesses of the two organic films is about 2 µm or more, the flatness thereof is improved, but the flatness may be lowered as the thickness of the organic film is reduced due to an outgas phenomenon in which gas leaks during a cure process.

In addition, referring to FIG. 18, the opening OP4 exposing the second data conductive layer is positioned in the second organic film 182 and the third organic film 183. The opening OP4 is shown by solid lines to indicate that it has the completed structure.

The anode connecting member ACM2 of the second data conductive layer is exposed through the opening OP4 positioned in the second organic film 182 and the third organic film 183 so that the anode (Anode) subsequently formed and the exposed anode connecting member ACM2 are electrically connected.

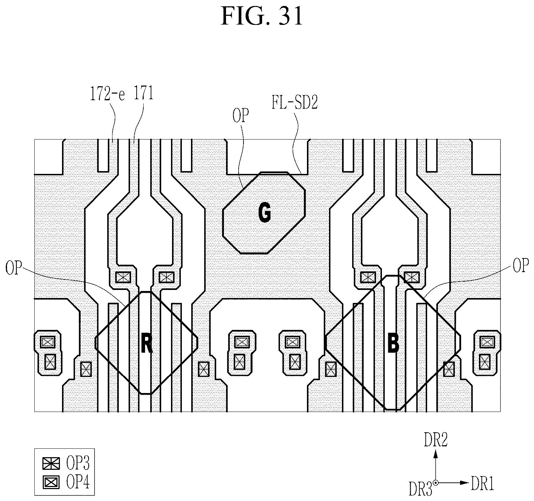

In some embodiments, the positions of red, green, and blue colors may be changed (refer to, e.g., FIG. 31); thus, the present invention is not be limited to any particular arrangement. In addition, in some embodiments, the halftone exposure area may be formed in both the second organic film 182 and the third organic film 183. As a result, at least one halftone exposure area may be formed corresponding to the positions in which the opening in the red, green, and blue pixel defining films and the anode (Anode) are formed.

FIG. 19 illustrates an entire structure to which the processes of FIG. 16 to FIG. 18 have been completed.

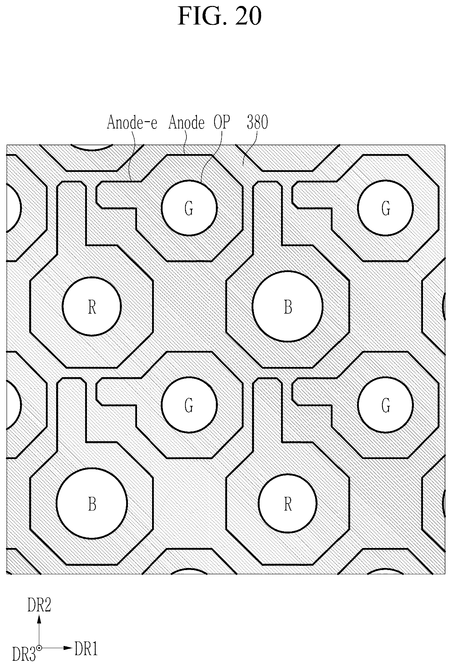

Referring to FIG. 20 and FIG. 22, the anode (Anode) is formed on the third organic film 183. The anode (Anode) may further include an extension (Anode-e) to receive a current from the pixel circuit part through the opening OP4.

Referring to FIG. 20 and FIG. 22, the black pixel defining film 380 is positioned on the anode (Anode), and the opening OP in the black pixel defining film 380 is formed to overlap the anode (Anode). The opening OP in the black pixel defining film 380 overlaps at least a portion of the anode (Anode).

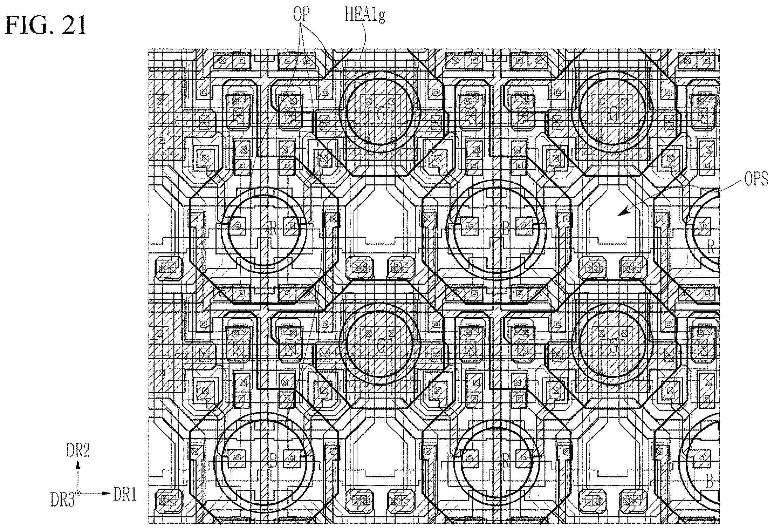

A structure in which the above structures are stacked as a whole is illustrated in FIG. 21.

In the present embodiment, the green first halftone exposure area HEA1g is formed in the second organic film 182 positioned between the data conductive layer and the anode, and the step or flatness value is about 30 nm or less only for the green light emitting area (see, e.g., FIG. 25), and the anode (Anode) positioned at the upper portion thereof may also be flat so that the green light is emitted at a low angle, that is, so that the green light component is increased before and after about 30 degrees based on the front (e.g., the third direction DR3), thereby reducing the reddish phenomenon and improving the display quality.

In addition, the light incident from the outside is reflected from the anode to prevent the phenomenon of color spreading/color separation/reflection color bands that asymmetrically spread. To prevent such asymmetrical reflection, all of the anodes included in the red, green, and blue light emitting diodes LED may be formed flat to a certain level or higher. To this end, in the present embodiment, two organic films, that is, the second organic film 182 and the third organic film 183, are formed on the second data conductive layer, and the extension FL-SD2 is formed on the second data conductive layer, while the extension FL-SD1 is also formed on the first data conductive layer, so that the anode may be formed flat.

In addition, referring to FIG. 19 and FIG. 21, when the light emitting display device DP has the optical sensor area OPS as shown in, for example, FIG. 5, each conductive layer or semiconductor layer positioned on the lower panel layer has a structure through which light can pass without a pattern being formed in the optical sensor area OPS. For example, a conductive layer or a semiconductor layer is not positioned in the optical sensor area OPS, and insulating films, such as an inorganic film and an organic film, may be stacked therein. However, in some embodiments, some of the inorganic and organic films of the lower panel layer may be omitted.

In some embodiments, when additional openings are formed in a light blocking member 220 or a red color filter 230R at a position corresponding to the optical sensor area OPS of the upper panel layer, the optical sensor on the rear surface may sense the front of the light emitting display device.

Even in a comparative (e.g., a normal) pixel, as shown in, for example, FIG. 21, the optical sensor area OPS may be positioned in the lower panel layer, but the light blocking member 220 or the red color filter 230R in the upper panel layer positioned on the optical sensor area OPS may not have any additional opening so that the optical sensor area OPS is not formed.

On the other hand, in some embodiments, if the wavelength band of light used by the optical sensor is not a visible ray band (e.g., infrared rays), the light blocking member 220 or the red color filter 230R may be positioned on the upper panel layer on the front of the optical sensor area OPS.

Based on the planar structure as described above, an entire cross-sectional structure of the light emitting display device will be described with reference to FIG. 22.

FIG. 22 illustrates a cross-sectional view of a light emitting display device according to an embodiment not according to the claimed invention.

FIG. 22 illustrates a structure up to the upper panel layer.

A detailed stacked structure of a pixel in the display area DA will be described with reference to FIG. 22. Here, the display area DA may have a stacked structure of pixels positioned in the main display area D1 (referred to as the first display area) and the component area D2 (referred to as the second display area). In addition, in the embodiment shown in FIG. 22, the pixel circuit part may refer to a configuration positioned below the second organic film 182 and the third organic film 183, and the light emitting diode may refer to a portion of a configuration positioned above the third organic film 183 and below the encapsulation layer 400. In addition, up to the encapsulation layer 400 is referred to as a lower panel layer, and a layer formed on the encapsulation layer 400 is referred to as an upper panel layer.

Hereinafter, a stacked structure of the display area DA shown in FIG. 22 will be briefly described.

The metal layer BML may be positioned on the substrate 110, and the metal layer BML may be positioned in an area overlapping a channel of a first semiconductor layer ACT1. The buffer layer 111 covering the metal layer BML is positioned on the metal layer BML, and the first semiconductor layer ACT1 is positioned on the buffer layer 111. The first semiconductor layer ACT1 includes a channel area, and a first area and a second area positioned at both sides of the channel area.

The first gate insulating film 141 may be positioned to cover the first semiconductor layer ACT1 or to overlap only the channel area of the first semiconductor layer ACT1. A first gate conductive layer GAT1 is positioned on the first gate insulating film 141, and the first gate conductive layer GAT1 includes a gate electrode of a transistor (e.g., LTPS TFT) including a silicon semiconductor. An area of the first semiconductor layer ACT1 overlapping the gate electrode in a plan view may be the channel area. In addition, the gate electrode may act as one electrode of a storage capacitor. The transistor (e.g., LTPS TFT) including the silicon semiconductor includes the first semiconductor layer ACT1 and a gate electrode of the first gate conductive layer GAT1 overlapping the first semiconductor layer ACT1 in a plan view.

The first gate conductive layer GAT1 is covered with the second gate insulating film 142, and the second gate conductive layer GAT2 is positioned on the second gate insulating film 142. The second gate conductive layer GAT2 may include a first storage electrode overlapping the gate electrode to configure a storage capacitor, and a lower shielding layer for an oxide semiconductor transistor positioned below an oxide semiconductor layer ACT2.

The second gate conductive layer GAT2 is covered by the first interlayer insulating film 161, and the oxide semiconductor layer ACT2 is positioned on the first interlayer insulating film 161, and the oxide semiconductor layer ACT2 includes a channel area and a first area and a second area positioned at both sides (e.g., opposite sides) of the channel area.

The oxide semiconductor layer ACT2 is covered by the third gate insulating film 143, and the third gate conductive layer GAT3 is positioned on the third gate insulating film 143. The third gate conductive layer GAT3 may include a gate electrode of an oxide semiconductor transistor (e.g., Oxide TFT) and a connecting member connected to the lower shielding layer for the oxide semiconductor transistor. The oxide semiconductor transistor (e.g., Oxide TFT) includes the oxide semiconductor layer ACT2 and a gate electrode of the third gate conductive layer GAT3 overlapping the oxide semiconductor layer in a plan view.

The third gate conductive layer GAT3 is covered by the second interlayer insulating film 162, and the first data conductive layer SD1 is positioned on the second interlayer insulating film 162. The first data conductive layer SD1 may include a connecting member so that it may provide a voltage or a current to the first semiconductor layer ACT1 and the oxide semiconductor layer ACT2 or to transmit a voltage or a current to other elements.

The first data conductive layer SD1 is covered by the first organic film 181, and the anode connecting member ACM2 of the second data conductive layer is positioned on the first organic film 181. The second data conductive layer may be connected to the first data conductive layer SD1 through the opening. The second data conductive layer is covered by the second organic film 182 and the third organic film 183.

Here, the second organic film 182 and the third organic film 183 each include a halftone exposure area HEA by exposing a partial area thereof with a reduced exposure amount. The halftone exposure area HEA shown in FIG. 22 is a combination of the halftone exposure areas HEA1g shown in FIG. 17 and FIG. 18 and displayed as one, may be positioned in the second organic film 182, and may be positioned in a portion corresponding to the green color filter. In addition, as shown in FIG. 22, the halftone exposure area HEA is positioned in an area overlapping the opening OP in the black pixel defining film or the anode (Anode) in a plan view, and it is shown that the halftone exposure area HEA may be formed at least partially wider than the opening OP of the black pixel defining film 380 or the anode (Anode).

The anode (Anode) may be positioned on the third organic film 183 and has a structure connected to the anode connecting member ACM2 of the second data conductive layer through the opening OP4 in the second organic film 182 and the third organic film 183. The anode (Anode) may be formed as a single layer including a transparent conductive oxide film or a metal material or as a multilayer including them. The transparent conductive oxide film may include an indium tin oxide (ITO), a poly-ITO, an indium zinc oxide (IZO), an indium gallium zinc oxide (IGZO), and an indium tin zinc oxide (ITZO). The metal material may include silver (Ag), molybdenum (Mo), copper (Cu), gold (Au), and aluminum (Al).

The black pixel defining film 380 having an opening OP (hereinafter also referred to as opening for anode exposure) overlapping at least a portion of the anode (Anode) and covering another portion of the anode (Anode) is positioned on the anode (Anode). The black pixel defining film 380 may further include a light blocking material in addition to an organic insulating material.

The spacer 385 is formed on the black pixel defining film 380. The spacer 385 may be formed in a stepped structure, and the spacer 385 may have a first portion 385-1 positioned in a high and narrow area and a second portion 385-2 positioned in a low and wide area. For example, the spacer 385 may include the first portion 385-1, and the second portion 385-2 having a lower height than the first portion 385-1 and integrally formed with the first portion 385-1.

The light emitting layer EML is positioned within the opening OP in the black pixel defining film 380 and on the anode (Anode). The functional layer FL is positioned on the spacer 385 and the exposed black pixel defining film 380, and the functional layer FL may be formed on the entire surface of the light emitting display panel DP. The functional layer FL may include an electron injection layer, an electron transport layer, a hole transport layer, and a hole injection layer, and the functional layer FL may be positioned above and below the light emitting layer EML. For example, the hole injection layer, the hole transport layer, the light emitting layer EML, the electron transport layer, the electron injection layer, and the cathode (Cathode) are sequentially positioned on the anode (Anode) so that the hole injection layer and the hole transport layer of the functional layer FL may be positioned at an upper portion of the light emitting layer EML, and the electron transport layer and the electron injection layer thereof may be positioned at a lower portion of the light emitting layer EML.

The cathode (Cathode) may be formed of a light transmissive electrode or a reflection electrode. The cathode may be integrally formed on the entire surface of the light emitting display panel DP except for the light transmission area. The cathode (Cathode) may be formed of a transparent conductive layer including an indium tin oxide (ITO), an indium zinc oxide (IZO), an indium gallium zinc oxide (IGZO), and an indium tin zinc oxide (ITZO), and it has a translucent characteristic so that it may reflect some light and transmit some light.

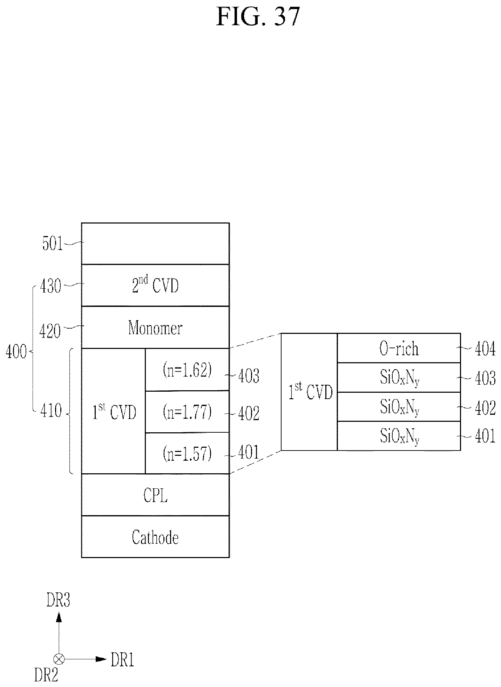

The encapsulation layer 400 is positioned on the cathode (Cathode). The encapsulation layer 400 includes at least one inorganic film and at least one organic film, and it may have a triple-layered structure including a first inorganic encapsulation layer, an organic encapsulation layer, and a second inorganic encapsulation layer. The encapsulation layer 400 may protect the light emitting layer EML made of an organic material from moisture or oxygen that may be introduced from the outside. In some embodiments, the encapsulation layer 400 may have a structure in which an inorganic layer and an organic layer are sequentially further stacked. A specific stacked structure of the encapsulation layer 400 according to the embodiment will be described in more detail with reference to FIG. 37.

The sensing insulating layers 501, 510, and 511 and two sensing electrodes 540 and 541 are positioned on the encapsulation layer 400 for touch sensing. The lower sensing insulating layer 501 is positioned on the encapsulation layer 400, the lower sensing electrode 541 is positioned thereon, the intermediate sensing insulating layer 510 is positioned thereon, the upper sensing electrode 540 is positioned thereon, and the upper sensing electrode 540 is positioned thereon, and the upper sensing insulating layer 511 is positioned thereon. The upper sensing electrode 540 and the lower sensing electrode 541 may be electrically connected or may be partially electrically separated from each other.

The light blocking member 220 and the color filter 230 are positioned on the upper sensing insulating layer 511.

The light blocking member 220 may be positioned to overlap the sensing electrodes 540 and 541 in a plan view and may be positioned to not overlap (e.g., to be offset from) the anode (Anode) in a plan view. This prevents the anodes (Anode) and the light emitting layer EML, which is configured to display an image, from being covered by the light blocking member 220 and the sensing electrodes 540 and 541.

The color filter 230 is positioned on the sensing insulating layers 501, 510, and 511 and the light blocking member 220. The color filter 230 includes a red color filter that transmits red light, a green color filter that transmits green light, and a blue color filter that transmits blue light. Each color filter 230 may be positioned to overlap the anode (Anode) of the light emitting diode in a plan view. Because light emitted from the light emitting layer EML may be emitted and then changed to a corresponding color by passing through a color filter, all of the light emitted from the light emitting layer EML may have the same color. However, light of different colors is displayed in the light emitting layer EML, and the displayed color may be enhanced by passing through a color filter of the same color.

The light blocking member 220 may be positioned between respective color filters 230. In some embodiments, the color filter 230 may be replaced with a color conversion layer or may further include a color conversion layer. The color conversion layer may include a quantum dot.

The planarization layer 550 covering the color filter 230 is positioned on the color filter 230. The planarization layer 550 may be a transparent organic insulating film. In some embodiments, a low refractive layer and an additional planarization layer may be further positioned on the planarization layer 550 to improve front visibility and light emitting efficiency of the display panel. Light may be emitted while being refracted to the front side by the low refractive layer and the additional planarization layer having a high refractive characteristic. In some embodiments, the low refractive layer and the additional planarization layer may be directly positioned on the color filter 230 when the planarization layer 550 is omitted.

In the present embodiment, no polarizer is formed on the planarization layer 550. A polarizer may prevent the display quality from being deteriorated while a user recognizes (or notices) external light that is incident to and reflected from the anode (Anode) and the like. However, in the present embodiment, the black pixel defining film 380 covers a lateral surface of the anode (Anode) to reduce a degree of reflection from the anode (Anode), and the light blocking member 220 is also formed to reduce an incident degree of light so that the light emitting display panel already includes a structure to prevent deterioration of display quality due to reflection. Therefore, a separately formed polarizer may be omitted from the front surface of the light emitting display panel DP.

A window may be positioned on the planarization layer 550, and in some embodiments, the planarization layer 550 may be omitted.

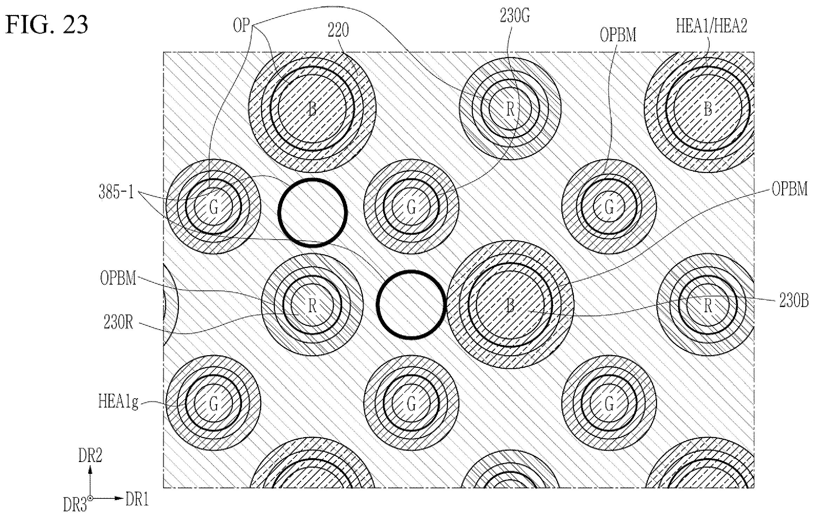

Hereinafter, a planar structure including an upper panel layer according to an embodiment will be described with reference to FIG. 23.

FIG. 23 illustrates a top plan view of a portion of an upper panel layer of a light emitting display device according to an embodiment.

In FIG. 23, the opening OP in the black pixel defining film 380 positioned on the lower panel layer and the first portion 385-1 of the spacer 385 are additionally shown to more clearly show the relationship between the upper panel layer and the lower panel layer. In addition, in FIG. 23, a planar position of the halftone exposure area HEA1g is also shown.

The light blocking member 220 includes the opening OPBM, and the opening OPBM may be formed to be relatively wider than and to overlap the opening OP in the black pixel defining film 380 in a plan view.

Color filters 230R, 230G, and 230B are positioned at a position corresponding to the opening OPBM in the light blocking member 220. The color filters 230R, 230G, and 230B may fill the opening OPBM in the light blocking member 220 and may be positioned on a portion of an upper surface of the light blocking member 220. The remaining portion of the upper surface of the light blocking member 220 may not be covered by the color filters 230R, 230G, and 230B. In FIG. 23, the color filters 230R, 230G, and 230B of respective colors and the light blocking member 220 are illustrated with different hatching lines so that they may be easily distinguished. In some embodiments, one of the color filters 230R, 230G, and 230B may have an opening and may be entirely disposed, and the other two thereof may have a structure that fills the opening.

Referring to FIG. 23, the position of the first portion 385-1 of the spacer 385 is shown, and it may be formed at a position overlapping the light blocking member 220 in a plan view. However, although the first portion 385-1 of the spacer 385 is formed on the black pixel defining film 380 in the third direction DR3, it is positioned under the light blocking member 220 in the third direction DR3.

In addition, the relationship between the halftone exposure area HEA1g shown in FIG. 23 and the anode (Anode) included in the green light emitting diode LED and the opening OP in the black pixel defining film 380 corresponding to the green light emitting area will be described as follows.

FIG. 23 shows that the halftone exposure area HEA1g has an area that is larger than the opening OP in the black pixel defining film 380 but smaller than the opening OPBM in the light blocking member 220. In addition, the halftone exposure area HEA1g overlaps the color filter 230G in a plan view.

However, different from the embodiment shown in FIG. 23, the halftone exposure area HEA1g may have a larger area than the opening OPBM in the light blocking member 220 in some embodiments.

As described above, the halftone exposure area HEA1g is formed to be larger than the opening OP in the black pixel defining film 380 so that the anode (Anode) exposed by the opening OP is formed flat as a whole (e.g., is flat across its entire surface).

As described above, the halftone exposure area HEA1g is formed only for green so that the anode (Anode) positioned in the green light emitting area may be formed to be more flat (e.g., to be flatter than anodes in other color light emitting areas) so that the green light component may be increased at a low angle, that is, around 30 degrees based on the front (the third direction DR3) to reduce the reddish phenomenon at a low angle and to improve the display quality.

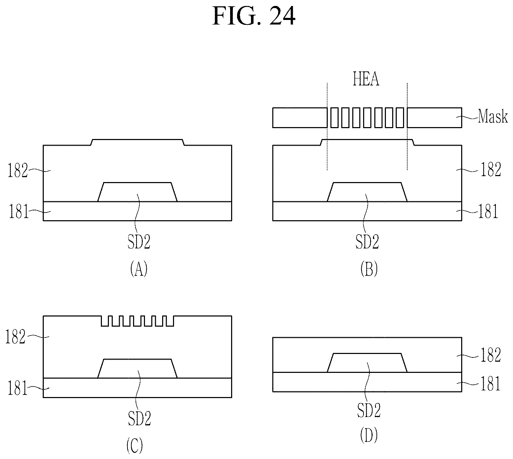

Hereinafter, a method of forming the halftone exposure area HEA1g by exposing with a reduced exposure amount by using a slit mask will be described with reference to FIG. 24.

FIG. 24 illustrates a step of planarizing an organic film by using a slit mask of a light emitting display device according to an embodiment.

In FIG. 24, the third organic film 183 is not shown and only the second organic film 182 is shown on the first organic film 181 because the halftone exposure area HEA1g is formed only in the second organic film 182 in the above-described embodiment. In some embodiments, however, the halftone exposure area may be formed in the third organic film 183, and in such an embodiment, an uppermost organic film may be the third organic film, and the halftone exposure area may be formed by the same process as that of FIG. 24.

Referring to FIG. 24, a step of forming the second data conductive layer SD2 on the first organic film 181 and then stacking the second organic film 182 covering them is shown as step (A).

As shown in FIG. 24, even when the second organic film 182 is coated, a step occurs in the second organic film 182 due to a height of the second data conductive layer SD2. Compared to an embodiment in which only the second organic film 182 is used, when the third organic film 183 is formed, the step may be reduced but, as shown in FIG. 25, a step of at least about 50 nm occurs even when two organic films (double VIA in FIG. 25) are used. Accordingly, steps (B), (C), and (D) in FIG. 24 are additionally performed so that a flatness value, that is, a step between the high and low portions of the organic film, is about 30 nm or less.

As shown in FIG. 24, the second organic film 182 is exposed by using a mask (Mask) including a slit in step (B). The slit in the mask (Mask) is formed at a position corresponding to the halftone exposure area HEA of the second organic film 182. In this embodiment, the second organic film 182 has a positive characteristic so that the exposed portion is removed, and when the exposure amount is reduced due to the slit, the removed portion is also reduced (e.g., less material is removed). Here, the slit in the mask (Mask) may have a transmittance greater than about 0% and smaller than about 15% compared to a transmittance of an open portion of the mask (Mask).

In some embodiments, the halftone exposure area HEA formed in the second organic film 182 may be more precisely planarized by more precisely forming the mask (Mask) including the slit. Generally, the slits formed in the mask (Mask) are formed at regular intervals as shown in FIG. 24 so that transmitted light may be transmitted at a constant ratio. However, in some embodiments, some slits may be formed thicker (e.g., wider or larger) to increase a portion covered to further decrease the transmittance of the corresponding portion, or some slits may be formed thinner (e.g., narrower or smaller) to further increase the transmittance of the corresponding portion. Through this method, the transmittance of the corresponding portion may be adjusted to about 1.5% or more and about 7.7% or less. Accordingly, after identifying an upper pattern before exposure of the halftone exposure area HEA of the second organic film 182, an exposure amount required for planarization is calculated according to the upper pattern of the halftone exposed area HEA, and accordingly, by differently forming slit patterns to provide the required exposure amount in each portion of the halftone exposure area HEA, the degree of planarization may be further improved.

Thereafter, when development is performed as shown in FIG. 24, a portion corresponding to the slit may have a slit pattern as shown in step (C). However, the pattern shown in the halftone exposure area HEA in step (C) of FIG. 24 may have a different shape from that of the slit. An extension direction the slit in the mask (Mask) shown in step (B) of FIG. 24 and an extension direction of the slit pattern shown in step (C) of FIG. 24 may be a direction perpendicular to an extension direction of the data line 171 in FIG. 17, for example, the first direction DR1. As a result, the planarization characteristic may be further improved.

Thereafter, when a cure step is performed as shown in step (D) of FIG. 24, gas is generated and the organic film shrinks so that the thickness thereof may be partially reduced. Thus, when the organic film is formed too thick, the amount of gas generated increases, the gas may affect other components, and the flatness of the organic film may deteriorate.

The second organic film 182 may be formed to have a thickness of about 1.5 µm but may have a value of greater than about 1 µm and smaller than about 2 µm. When the thickness of the second organic film 182 is about 1 µm, the planarization characteristic may not be good, and when the thickness of the second organic film 182 is about 2 µm or more, the flatness is improved, but in the step (D) of FIG. 24, the flatness may be deteriorated as the thickness of the organic film decreases due to an outgas phenomenon in which gas leaks.

By adjusting the process and the thickness of the organic film as described above, the halftone exposure area of the organic film may have the step or flatness value of about 30 nm or less.

Hereinafter, a planarization characteristic of the present embodiment will be described with reference to FIG. 25.

FIG. 25 is a graph of a flat characteristic in a light emitting display device according to embodiments.

A flatness value measured in FIG. 25 is a value measured based on a height difference between the highest point and the lowest point of the upper surface of the anode (Anode) formed on the organic film instead of measuring the flatness of the upper surface of the organic film. This is to measure it by using the anode (Anode) that is positioned on the organic film and has a more clearly visible boundary because the boundary may be unclear when actually photographing the organic film, and in some embodiments, when the anode (Anode) includes a plurality of layers, it may be measured by using the most visible layer, and in some embodiments, it may be measured by using a height difference between the highest point and the lowest point of the lower surface of the anode (Anode). As described, because the flatness of the organic film may be measured by using the anode (Anode), the flatness of the organic film and the flatness of the anode (Anode) may be substantially the same and are used interchangeably throughout the specification. Here, the larger the flatness value is, the worse the flatness is (e.g., the rougher the surface is), and the smaller the flatness value is, the better the flatness is (e.g., the flatter the surface is).

The flatness characteristics of three examples will be described with reference to FIG. 25.

In FIG. 25, "single VIA" is a comparative example in which only one organic film is formed on the second data conductive layer, "double VIA" is a comparative example in which two organic films are formed on the second data conductive layer, and both are examples in which no halftone exposure area is additionally formed. In FIG. 25, "double VIA + Slit" is an embodiment of the present invention in which two organic films are formed on the second data conductive layer and the halftone exposure area is additionally formed so that it is further planarized.

The numerical values shown in FIG. 25 represent the average flatness values of respective tested examples; the average flatness value of "single VIA" is 160.285 nm; the average flatness value of "double VIA" is 61.5318 nm; and the average flatness value of "double VIA + Slit" of the present embodiment is 20.3545 nm, and it can be seen that the flatness is greatly reduced in the present embodiment (double VIA + Slit).

In an embodiment in which the halftone exposure area is formed in the second organic film 182 positioned below the anode of the green light emitting diode LED to make it more flat to prevent external light from being asymmetrically reflected; and by making it flatter than the anodes of the red and blue light emitting diodes LED, the green light component is increased at a low angle, that is, around 30 degrees based on the front (e.g., the third direction DR3), thereby reducing the reddish phenomenon at a low angle and improving the display quality.

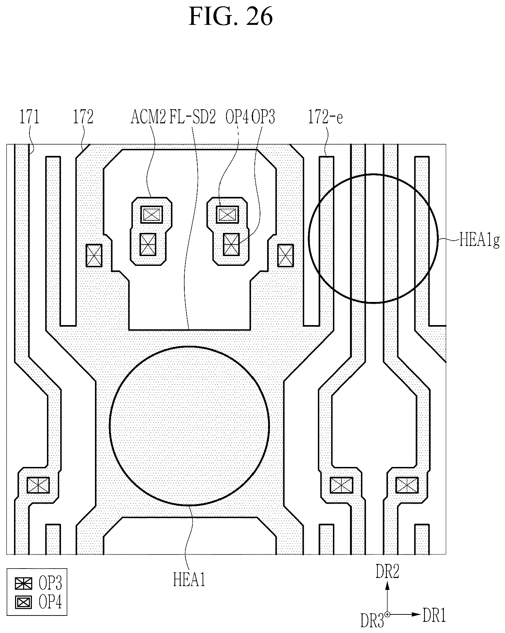

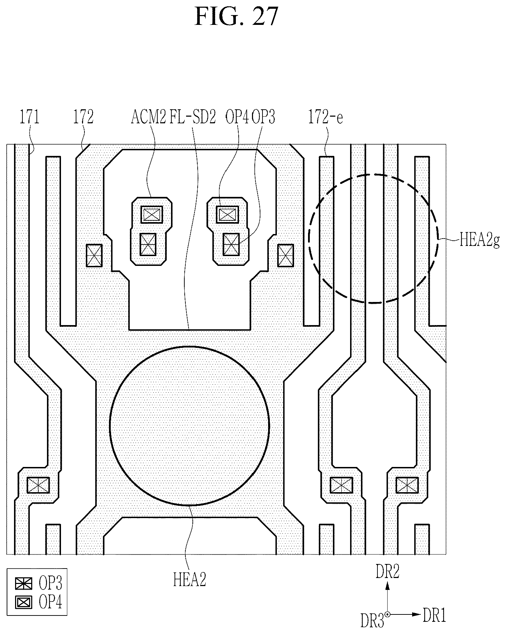

Hereinafter, an embodiment in which the halftone exposure area is formed in the second organic film 182 and the third organic film 183 positioned under the anodes included in the red and blue light emitting diodes LED in addition to the green light emitting diode to be flatter will be described with reference to FIG. 26 and FIG. 27.

FIG. 26 and FIG. 27 illustrate modified embodiments of FIG. 17 and FIG. 18.

FIG. 26 and FIG. 27 correspond to FIG. 17 and FIG. 18, respectively, and the first halftone exposure areas HEA1 and HEA1g and the second halftone exposure area HEA2 are indicated by solid lines so that the organic films 182 and 183 may be more planarized through actual halftone exposure.

Referring to FIG. 26, the second organic film 182 is formed on the second data conductive layer, and a partial area of the second organic film 182 is exposed by reducing an amount of exposure by using a slit mask. After that, as shown in FIG. 27, the third organic film 183 is additionally formed, and a partial area of the third organic film 183 is exposed by reducing an amount of exposure by using a slit mask.

FIG. 26 illustrates the first halftone exposure areas HEA1 and HEA1g formed in the second organic film 182 on the second data conductive layer, and FIG. 27 illustrates the second halftone exposure area HEA2 formed in the third organic film 183 positioned on the second organic film 182.

Referring to FIG. 26, after stacking the second organic film 182 on the upper portion of the second data conductive layer, the first halftone exposure areas HEA1 and HEA1g are formed by exposing a partial area thereof with a reduced exposure amount by using a slit mask. Here, the first halftone exposure areas HEA1 and HEA1g may overlap all of the opening in the black pixel defining film in a plan view corresponding to the position at where the opening in the black pixel defining film and the anode (Anode) are formed in the subsequent process and may overlap at least a portion of the anode (Anode) in a plan view. From among the two first halftone exposure areas HEA1 and HEA1g shown in FIG. 26, a (1-1)-th halftone exposure area HEA1 corresponds to a portion in which the anode (Anode) of the red and blue light emitting diodes LED are positioned in the opening in the black pixel defining film, and a (1-2)-th halftone exposure area HEA1g corresponds to a portion in which the anode (Anode) of the green light emitting diode LED is positioned in the opening in the black pixel defining film. Hereinafter, the (1-1)-th halftone exposure area HEA1 is the first halftone exposure area corresponding to the red or blue anode (Anode) so it is also referred to as a red or blue first halftone exposure area HEA1, and the (1-2)-th halftone exposure area HEA1g is also referred to as a green first halftone exposure area HEA1g.

Referring to FIG. 26, the red or blue first halftone exposure area HEA1 also overlaps the extension FL-SD2 of the second data conductive layer in a plan view. In addition, the green first halftone exposure area HEA1g has a structure overlapping the data line 171 and the wire portion 172-e of the second data conductive layer and overlaps a total of four wires. In addition, the green first halftone exposure area HEA1g also has a structure overlapping the extension FL-SD1 of the first data conductive layer positioned in the first data conductive layer in a plan view.

Here, the second organic film 182 may be formed to have a thickness of about 1.5 µm but may have a value of greater than about 1 µm and smaller than about 2 µm. When the thickness of the second organic film 182 is about 1 µm, the planarization characteristic may not be good even if two organic films are formed to each have about a 1 µm thickness. When each of the thicknesses of the two organic films is about 2 µm or more, the flatness thereof is improved, but the flatness may be lowered as the thickness of the organic film is reduced due to an outgas phenomenon in which gas leaks in the cure process as shown in step (D) of FIG. 24.

Referring to FIG. 27, after stacking the third organic film 183 on the second organic film 182, the first halftone exposure area HEA2 is formed by exposing a partial area thereof with a reduced exposure amount by using a slit mask. Here, the second halftone exposure area HEA2 is formed in an area corresponding to the red or blue first halftone exposure area HEA1 from among the first halftone exposure areas HEA1 and HEA1g but is not formed in an area corresponding to the green first halftone exposure area HEA1g. For example, the second halftone exposure area HEA2 may overlap all of the opening in the black pixel defining film in a plan view corresponding to the position where the opening in the red or blue areas of the black pixel defining film and the anode (Anode) are formed in the subsequent process and may overlap at least a portion of the anode (Anode) in a plan view. In this embodiment, because the second halftone exposure area HEA2 is not formed in a portion corresponding to the green light emitting diode/anode, the second halftone exposure area HEA2 is hereinafter referred to as the red or blue second halftone exposure area HEA2.

In FIG. 27, the second halftone exposure area HEA2 indicated by the solid line overlaps at least a portion of the red or blue first halftone exposure area HEA1 halftone-exposed on the second organic film 182, and the second halftone exposure area HEA2 that is halftone-exposed is also positioned on the third organic film 183. Here, the red or blue first halftone exposure area HEA1 and the red or blue second halftone exposure area HEA2 overlap each other in a plan view, and at least one of them may include the other thereof in a plan view and may be formed with a relatively large area. In some embodiments, the slit mask for forming the first red or blue halftone exposure area HEA1 and the slit mask for forming the red or blue second halftone exposure area HEA2 may be the same so that they may have the same area.

In FIG. 27, the green first halftone exposure area HEA1g is also shown by a dotted line. In FIG. 27, the green first halftone exposure area HEA1g shown by a dotted line is only for showing that it is halftone-exposed on the second organic film 182, and the third organic film 183 is not halftone-exposed.

Referring to FIG. 27, the red or blue second halftone exposure area HEA2 overlaps the extension FL-SD2 of the second data conductive layer and the first halftone exposure area HEA1 in a plan view.

Here, the third organic film 183 may be formed to have a thickness of about 1.5 µm but may have a value of greater than about 1 µm and smaller than about 2 µm. When the thickness of the third organic film 183 is about 1 µm, even if the two organic films 182 and 183 are formed to each have a thickness of about 1 µm, the planarization characteristic may not be good. Further, when each of the thicknesses of the two organic films is about 2 µm or more, the flatness thereof is improved, but the flatness may be lowered as the thickness of the organic film is reduced due to an outgas phenomenon in which gas leaks in the cure process as shown in step (D) of FIG. 24.

The aspects and features of the embodiments shown in FIG. 6 to FIG. 16 and FIG. 19 to FIG. 25 described above may be applied to the embodiments shown in FIG. 26 and FIG. 27 as described above except for FIG. 17 and FIG. 18.

Different from the embodiments shown in FIG. 17 and FIG. 18, in the embodiments shown in FIG. 26 and FIG. 27, the planarization is additionally performed by using a slit mask on the second organic film 182 and the third organic film 183 positioned under the anodes included in the red and blue light emitting diodes LED. The second organic film 182 and the third organic film 183 positioned under the anode included in the green light emitting diode LED are the same in the embodiments shown in FIG. 26 and FIG. 27 and the embodiments shown in FIG. 17 and FIG. 18. That is, only the second organic film 182 positioned under the anode included in the green light emitting diode LED is additionally planarized by using a slit mask, and the third organic film 183 is not additionally planarized.

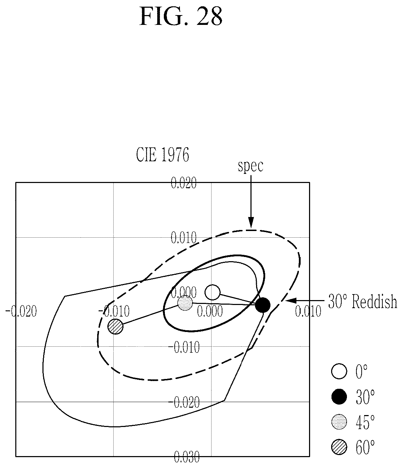

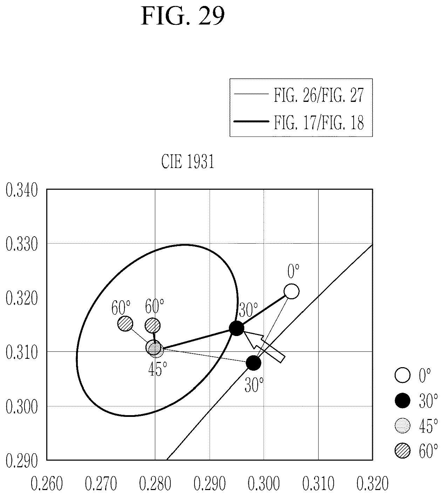

Hereinafter, a difference between the embodiments shown in FIG. 26 and FIG. 27 and the embodiments shown in FIG. 17 and FIG. 18 will be described with reference to FIG. 28 and FIG. 29.

FIG. 28 and FIG. 29 are graphs of color coordinate values according to angles.

First, in FIG. 28, color coordinates at a specific angle based on the front for the embodiment of FIG. 26 and FIG. 27 are shown on CIE 1976 color coordinates.

In manufacturing the light emitting display device, it is formed while matching color coordinate values at the front (0°) and at 45°. However, the color coordinate values change as the angle changes with respect to the front (0°).

In the embodiments shown in FIG. 26 and FIG. 27, the color coordinate values change with a certain tendency at angles of the front (0°), 45°, and 60°. However, the color coordinate values at 30° in FIG. 28 are positioned further to the right, unlike other angles. Although the color coordinate values at 30° are within the specification, which is a display standard required for the light emitting display device, it is positioned at the right side and has a reddish characteristic including more red color on the color coordinates. Accordingly, when viewing the light emitting display device of the embodiment of FIG. 26 and FIG. 27 from the front while changing the angle, a reddish image may be viewed at around 30° and the display quality may deteriorate.

In FIG. 28, the embodiment shown in FIG. 26 and FIG. 27 and the embodiment shown in FIG. 17 and FIG. 18 are compared and illustrated in CIE 1931 color coordinates.

As shown in FIG. 29, in both the embodiment shown in FIG. 26 and FIG. 27 and the embodiment shown in FIG. 17 and FIG. 18, there is no difference between the color coordinate values at the angles of the front (0°) and 45° because they are matched during manufacturing. However, because the color coordinate values change as the angle changes with respect to the front (0°), there are different color coordinate values at 30° and 60°.

As indicated by the arrow in FIG. 28, the color coordinate value at 30° is not positioned at the right side in the embodiment shown in FIG. 17 and FIG. 18, unlike the embodiment shown in FIG. 26 and FIG. 27. This is a portion with relatively little red color on the color coordinates, and the reddish characteristic does not occur in the embodiment shown in FIG. 17 and FIG. 18.

In the embodiment shown in FIG. 17 and FIG. 18, only the second organic film 182 positioned under the anode included in the green light emitting diode LED is additionally planarized by using a slit mask, while the second organic film 182 and the third organic film 183 positioned under the anodes included in the red and blue light emitting diodes LED are not additionally planarized. In the anode of the green light emitting diode LED that is more flatly formed, the green light component may be increased at a low angle, that is, before and after 30 degrees based on the front (e.g., the third direction DR3). In the anodes of the red and blue light emitting diodes LED with relatively low flatness, the component of the corresponding color may be increased at an angle greater than a low angle, that is, around 45 degrees or around 60 degrees based on the third direction DR3. As a result, at a low angle (e.g., about 30 degrees based on the front (the third direction DR3)), the green component is increased and the red component is reduced, thereby reducing the reddish phenomenon.

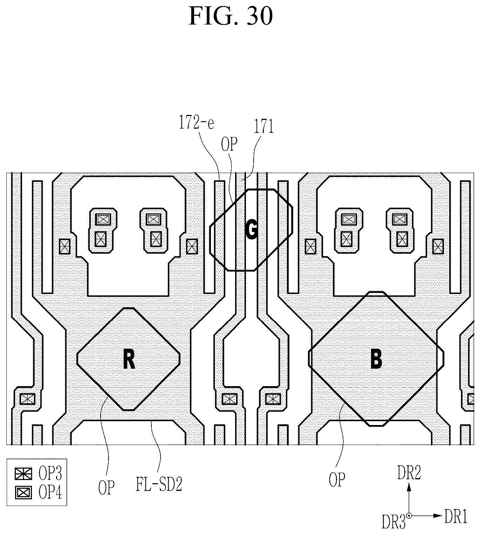

Hereinafter, another embodiment will be described with reference to FIG. 30 and FIG. 31.

FIG. 30 and FIG. 31 respectively illustrate another modified embodiment.

FIG. 30 and FIG. 31 illustrate the opening OP in the pixel defining film 380, and the opening OP in the pixel defining film 380 may have a polygonal structure rather than a circular structure and may have a structure in which corners are chamfered. In the embodiment shown in FIG. 20 and FIG. 21, described above, the opening OP in the pixel defining film 380 has a circular shape, and there is a difference in planar structure.

Referring to the embodiment shown in FIG. 30, the openings OP in the pixel defining film 380 corresponding to the red (R) and blue (B) light emitting diodes LED, that is, the red and blue light emitting areas, overlap the extension FL-SD2 of the second data conductive layer in a plan view, and the opening OP of the pixel defining film 380 corresponding to the green (G) light emitting diode LED, that is, the green light emitting area, overlaps the data line 171 of the second data conductive layer and the protruding wire portion 172-e of the driving voltage line 172 in a plan view. The opening OP in the pixel defining film 380 corresponding to the green (G) light emitting diode LED may overlap the extension FL-SD1 of the first data conductive layer in a plan view. This has the same layout as the embodiment described above.

However, in FIG. 31, an embodiment in which the positions of the openings OP in the pixel defining film 380 corresponding to the red (R) and blue (B) light emitting diodes LED and the opening OP in the pixel defining film 380 corresponding to the green (G) light emitting diode LED are reversed is shown. For example, in FIG. 31, the openings OP in the pixel defining film 380 corresponding to the red (R) and blue (B) light emitting diodes LED, that is, the red and blue light emitting areas, overlap the data line 171 of the data conductive layer and the protruding wire portion 172-e of the driving voltage line 172 in a plan view, and the opening OP in the pixel defining film 380 corresponding to the green (G) light emitting diode LED, that is, the green light emitting area, overlaps the extension FL-SD2 of the second data conductive layer in a plan view. The openings OP in the pixel defining film 380 corresponding to the red (R) and blue (B) light emitting diodes LED may overlap the extension FL-SD1 of the first data conductive layer in a plan view.

Even in the embodiment shown in FIG. 31, when the reddish phenomenon occurs at a low angle (e.g., about 30 degrees based on the front (the third direction DR3)), as in the embodiment shown in FIG. 17 and FIG. 18, only a portion of the organic film positioned under the anode included in the green light emitting diode LED may be additionally planarized by using a slit mask. In such an embodiment, portions of the second organic film 182 and/or the third organic film 183 positioned under the anodes included in the red and blue light emitting diodes LED may not undergo additional planarization.

In the above, the embodiment in which the reddish phenomenon is removed at the low angle while additionally planarizing only the portion of the organic film positioned under the anode included in the green light emitting diode LED by using the slit mask has been described.

However, in some embodiments, the reddish phenomenon at a low angle may be removed in a different manner. Hereinafter, an embodiment in which an insulating layer lens having a difference in refractive index is formed in a front surface of red and blue light emitting areas so that light is transmitted to the front, and an insulating layer lens structure having a difference in refractive index is not formed in a front surface of a green light emitting area, so that a reddish phenomenon in which a lot of red color generated at a low angle with respect to the front of a light emitting display device is eliminated, will be described.

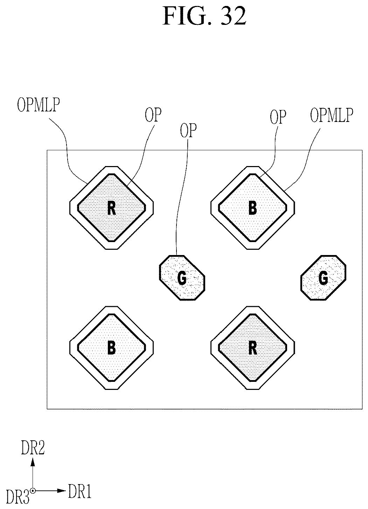

First, a planar structure thereof will be described with reference to FIG. 32.

FIG. 32 illustrates a schematic top plan view of a portion of a light emitting display device according to another embodiment.

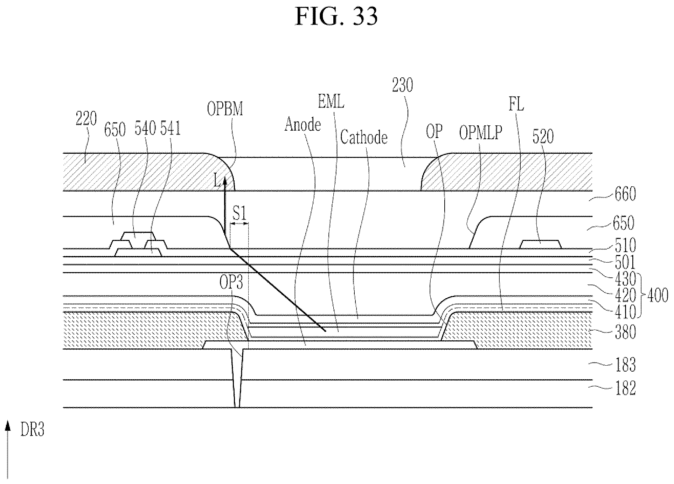

In FIG. 32, the opening OP in the pixel defining film 380 and the insulating layer lens OPMLP positioned at the upper side of the front of the pixel defining film 380, that is, the third direction DR3, are illustrated. Here, referring to FIG. 33, the insulating layer lens OPMLP includes two insulating layers having different refractive indexes including a first insulating layer 650 having a low refractive index has an opening OPMLP and a second insulating layer 660 having a high refractive index covering the first insulating layer 650. The second insulating layer 660 may also be positioned within the opening OPMLP in the first insulating layer 650 and may entirely cover an upper surface of the first insulating layer 650. The insulating layer lens OPMLP shown in FIG. 32 uses the same reference numeral corresponding to a boundary of the opening OPMLP of the first insulating layer 650.

Referring to FIG. 32, the insulating layer lens OPMLP is positioned at the front of the opening OP in the pixel defining film 380 corresponding to the red and blue light emitting areas, but the insulating layer lens OPMLP is not positioned at the front of the opening OP in the pixel defining film 380 corresponding to the green light emitting area. The insulating layer lens OPMLP has a larger area than the opening OP in the pixel defining film 380 corresponding to the light emitting area, and the opening OP in the pixel defining film 380 is positioned within the insulating layer lens OPMLP in a plan view.

The insulating layer lens OPMLP allows light emitted from the opening OP in the pixel defining film 380, that is, the light emitting area, to be emitted while being bent in the front direction, that is, the third direction DR3, due to a difference in refractive index, thereby improving the display luminance, and it allows the display luminance to be reduced on the side including the low angle. In the embodiment shown in FIG. 32, because only red and blue light are bent to the front, components of red and blue light are reduced on the side including a low angle, that is, about 30 degrees based on the front (e.g., the third direction DR3). However, because the insulating layer lens OPMLP does not exist in the green light emitting areas, the green light is not bent in the front direction so the component of the green light is not reduced at the side including the low angle.

In the embodiment shown in FIG. 26 and FIG. 27 described above, the reddish characteristic occurs at a low angle, but when the insulating layer lens OPMLP as shown in FIG. 32 is further included in the third direction DR3, the reddish characteristic may be reduced.

A cross-sectional structure of the embodiment reducing the reddish characteristic as described above will be described with reference to FIG. 33.

FIG. 33 illustrates a cross-sectional view of a portion of the light emitting display device according to the embodiment shown in FIG. 32.

In FIG. 33, a structure below the second organic film 182 is omitted. A lower structure of the second organic film 182 may be the same as that shown in FIG. 7 to FIG. 22.

As in the embodiment shown in FIG. 17 and FIG. 18 or FIG. 26 and FIG. 27, at least portions of the second organic film 182 and the third organic film 183 are additionally planarized by using a slit mask.

The anode (Anode) is positioned on the third organic film 183, and the pixel defining film 380 exposes a portion of the anode (Anode) and has the opening OP corresponding to the light emitting area. The light emitting layer EML may be positioned within the opening OP in the pixel defining film 380, and the functional layer FL may be positioned above and below the light emitting layer EML. The functional layer FL and the light emitting layer EML are collectively referred to as an intermediate layer, and the functional layer FL and/or the intermediate layer may be formed on the entire surface of the light emitting display device. The cathode (Cathode) is positioned on the pixel defining film 380, the light emitting layer EML, and the functional layer FL.

The encapsulation layer 400 is positioned on the cathode (Cathode), and the encapsulation layer 400 may include at least one inorganic film and at least one organic film. In the present embodiment, the encapsulation layer 400 may include a first inorganic encapsulation layer 410, an organic encapsulation layer 420, and a second inorganic encapsulation layer 430. However, this is just one example, and an encapsulation layer 400 having a structure as shown in FIG. 37 may be formed. In some embodiments, the organic encapsulation layer 420 may be formed around the display area DA, and the first inorganic encapsulation layer 410 and the second inorganic encapsulation layer 430 may be positioned up to the non-display area PA. The encapsulation layer 400 is to protect the light emitting diode LED from moisture or oxygen that may be introduced from the outside, and one end portions of the first inorganic encapsulation layer 410 and the second inorganic encapsulation layer 430 may directly contact each other.

The lower sensing insulating layer 501 may be positioned on the encapsulation layer 400. The lower sensing insulating layer 501 may be formed as an inorganic insulating film, and an inorganic material included in the inorganic insulating film may be at least one of a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, and a silicon oxynitride. In some embodiments, the lower sensing insulating layer 501 may be omitted.

The sensing electrode connecting portion 541, the first sensing insulating layer 510, and the plurality of sensing electrodes 520 and 540 may be positioned on the lower sensing insulating layer 501. The sensing electrode connecting portion 541 may be positioned on the same layer as the plurality of sensing electrodes 520 and 540, and the other thereof may be positioned on a different layer from the plurality of sensing electrodes 520 and 540. Hereinafter, an embodiment in which the sensing electrode connecting portion 541 is positioned on a different layer from the plurality of sensing electrodes 520 and 540 will be described.

The sensing electrode connecting portion 541, the first sensing insulating layer 510, and the plurality of sensing electrodes 520 and 540 may configure a sensing sensor. The sensing sensor may be classified into a resistive type, a capacitive type, an electro-magnetic type, an optical type, and the like. The sensing sensor according to the embodiment may use a capacitance type of sensor.

The sensing electrode connecting portion 541 may be positioned on the lower sensing insulating layer 501, and the first sensing insulating layer 510 may be positioned on the lower sensing insulating layer 501 and the sensing electrode connecting portion 541. The first sensing insulating layer 510 may include an inorganic insulating material or an organic insulating material. The inorganic insulating material may include at least one of a silicon nitride, an aluminum nitride, a zirconium nitride, a titanium nitride, a hafnium nitride, a tantalum nitride, a silicon oxide, an aluminum oxide, a titanium oxide, a tin oxide, a cerium oxide, and a silicon oxynitride. The organic insulating material may include at least one of an acryl-based resin, a methacrylic-based resin, a polyisoprene, a vinyl-based resin, an epoxy-based resin, a urethane-based resin, a cellulose-based resin, and a perylene-based resin.

The plurality of sensing electrodes 520 and 540 may be positioned on the first sensing insulating layer 510. The plurality of sensing electrodes 520 and 540 may include a plurality of first sensing electrodes 520 and a plurality of second sensing electrodes 540. The first sensing electrode 520 and the second sensing electrode 540 may be electrically insulated from each other. The first sensing insulating layer 510 includes an opening exposing an upper surface of the sensing electrode connecting portion 541, and the sensing electrode connecting portion 541 may be connected to the second sensing electrode 540 through an opening in the first sensing insulating layer 510 to electrically connect two second sensing electrodes 540 adjacent to each other. According to embodiments, another sensing electrode connecting portion for connecting the first sensing electrode 520 may be formed.

The plurality of sensing electrodes 520 and 540 may include a conductive material having good conductivity. For example, the plurality of sensing electrodes 520 and 540 may include a metal, such as aluminum (Al), copper (Cu), silver (Ag), gold (Au), platinum (Pt), palladium (Pd), nickel (Ni), molybdenum (Mo), tungsten (W), titanium (Ti), chromium (Cr), tantalum (Ta), or a metal alloy thereof. The plurality of sensing electrodes 520 and 540 may be formed of a single layer or a multilayer. The plurality of sensing electrodes 520 and 540 may have openings so that light emitted from the light emitting diode is emitted upwardly without interference. In some embodiments, the plurality of sensing electrodes 520 and 540 may be configured as a triple layer including an upper layer, an intermediate layer, and a lower layer, and the upper layer and the lower layer may include titanium (Ti) while the intermediate layer may include aluminum (Al).

A first insulating layer 650 is positioned on the plurality of sensing electrodes 520 and 540 and the first sensing insulating layer 510. The first insulating layer 650 may include a light transmitting organic insulating material having a low refractive index. For example, the first insulating layer 650 may include an acrylic resin, a polyimide resin, a polyamide resin, and Alq3 [Tris(8-hydroxyquinolinato)aluminum]. The first insulating layer 650 may have a relatively smaller refractive index than the second insulating layer 660, which will be described later. For example, the first insulating layer 650 may have a refractive index in a range of about 1.40 to about 1.59.

The first insulating layer 650 has an opening OPMLP. Here, the opening OPMLP may correspond to the insulating layer lens OPMLP shown in FIG. 32. Referring to FIG. 32, because the insulating layer lens OPMLP is not positioned in the green light emitting diode LED, the cross-sectional structure shown in FIG. 32 shows a portion corresponding to the red or blue light emitting diode LED.

The opening OPMLP in the first insulating layer 650 refers to a portion in which the first sensing insulating layer 510 is not covered by the first insulating layer 650. The opening OPMLP in the first insulating layer 650 may overlap the opening OP in the pixel defining film 380 in a plan view, and a boundary of the opening OP in the pixel defining film 380 and a boundary of the opening OPMLP in the first insulating layer 650 has a separation distance S1 in a plan view. As a result, the opening OP in the pixel defining film 380 is positioned within the opening OPMLP in the first insulating layer 650 in a plan view, and a planar size of the opening OPMLP in the first insulating layer 650 may be larger than a planar size of the opening OP in the pixel defining film 380.

The distance S1 between the opening OP in the pixel defining film 380 and the opening OPMLP in the first insulating layer 650 refers to the shortest distance between an edge of the opening OP in the pixel defining film 380 and an edge of the opening OPMLP. The edge of the opening OP in the pixel defining film 380 may refer to a planar shape formed by a lower portion of the edges of the pixel defining film 380 that contacts the anode (Anode). The edge of the opening OPMLP in the first insulating layer 650 may refer to a planar shape formed by a lower portion of the edge of the first insulating layer 650 that contacts the first sensing insulating layer 510.

The separation distance S1 between the opening OP in the pixel defining film 380 and the opening OPMLP in the first insulating layer 650 may not be constant depending on positions of the opening OP in the pixel defining film 380 and the opening OPMLP.

The second insulating layer 660 may be positioned on the first sensing insulating layer 510 and the first insulating layer 650. The second insulating layer 660 may include a light transmitting organic insulating material having a high refractive index. The second insulating layer 660 may have a relatively larger refractive index than the first insulating layer 650. For example, the second insulating layer 660 may have a refractive index in a range of about 1.60 to about 1.80.

The second insulating layer 660 may also be positioned in the opening OPMLP in the first insulating layer 650. The second insulating layer 660 may contact the side surface of the first insulating layer 650 within the opening OPMLP. In addition, because the second insulating layer 660 is also positioned on the upper surface of the first insulating layer 650, the upper surface of the first insulating layer 650 and the second insulating layer 660 are in contact with each other.

By further including the first insulating layer 650 and the second insulating layer 660 positioned in the opening OPMLP in the first insulating layer 650 on the front surface of the light emitting layer EML, the light emitting efficiency may be improved in the front direction (e.g., the third direction DR3). For example, at least some of the light generated from the light emitting diode LED may be totally reflected or reflected at the interface between the first insulating layer 650 and the second insulating layer 660 to be condensed to the front. In the cross-sectional structure corresponding to the green light emitting diode LED, the first insulating layer 650 and the second insulating layer 660 are stacked, but the first insulating layer 650 does not have the opening OPMLP so that the insulating layer lens OPMLP may not be formed. Therefore, referring to FIG. 32 and FIG. 33, red and blue light may be condensed to the front but green light may not be condensed to the front.

The improvement in light emitting efficiency in the front direction is described as follows.

Light L generated from the light emitting layer EML is emitted in various directions and is incident to the first insulating layer 650 and the second insulating layer 660 at various incident angles. Some of the light L is incident on the boundary surface between the first insulating layer 650 and the second insulating layer 660 and is totally reflected or reflected due to the difference in refractive index between the first insulating layer 650 and the second insulating layer 660. When the incident angle of the light L incident on the boundary surface is larger than the critical angle, the incident light L may be totally reflected on the boundary surface between the first insulating layer 650 and the second insulating layer 660. When the light L incident on the second insulating layer 660 having a relatively high refractive index proceeds to the first insulating layer 650 having a relatively small refractive index and the incident angle is larger than a certain angle (e.g., the critical angle), total reflection occurs at the boundary surface between the first insulating layer 650 and the second insulating layer 660. In this way, the direction of the light L that should proceed to the side surface is changed to the front surface at the boundary surface between the first insulating layer 650 and the second insulating layer 660, thereby improving luminance at the front surface and improving the light emitting efficiency.

Referring to FIG. 33, the color filter 230 and the light blocking member 220 are positioned on the second insulating layer 660.

The light blocking member 220 may be positioned so that it does not overlap the anode (Anode) in a plan view to prevent the anode (Anode) and the light emitting layer EML, which are configured to display an image, from being covered by the light blocking member 220, and the opening OPBM in the light blocking member 220 is positioned in an area overlapping the anode (Anode) and the light emitting layer EML in a plan view.

The color filter 230 is positioned on the second insulating layer 660 and the light blocking member 220. The color filter 230 includes a red color filter that transmits red light, a green color filter that transmits green light, and a blue color filter that transmits blue light. The color filter 230 shown in FIG. 33 may be a red or blue color filter 230. Each color filter 230 may be positioned to overlap the anode (Anode) of the light emitting diode in a plan view. Because light emitted from the light emitting layer EML may be emitted while being changed to a corresponding color while passing through a color filter, all of the light emitted from the light emitting layer EML may have the same color. However, light of different colors is displayed in the light emitting layer EML, and the displayed color may be enhanced by passing through a color filter of the same color.

The light blocking member 220 may be positioned between respective color filters 230. In some embodiments, the color filter 230 may be replaced with a color conversion layer or may further include a color conversion layer. The color conversion layer may include a quantum dot.

A planarization layer or a window may be positioned on the light blocking member 220 and the color filter 230, but a polarizer may not be included. For example, the polarizer may prevent the display quality from being deteriorated when a user recognizes external light that is incident to and reflected by the anode (Anode) and the like. However, in the present embodiment, the black pixel defining film 380 covers a lateral surface of the anode (Anode) to reduce a degree of reflection from the anode (Anode), and the light blocking member 220 is also formed to reduce an incident degree of light so that the light emitting display panel already includes a structure to prevent deterioration of display quality due to reflection. Therefore, a polarizer may be omitted from the front surface of the light emitting display panel DP.

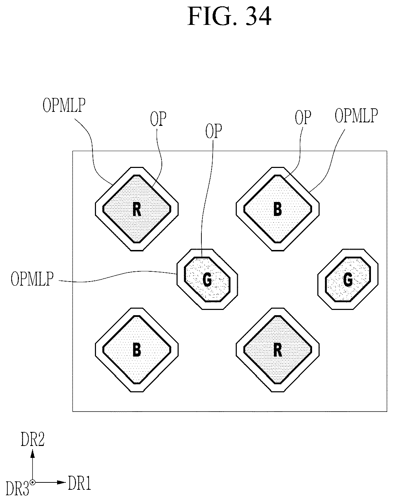

Hereinafter, a modified embodiment comparable to that shown in FIG. 32 will be described with reference to FIG. 34.

FIG. 34 illustrates a modified embodiment of FIG. 32.

Different from the embodiment shown in FIG. 32, in FIG. 34, the insulating layer lens OPMLP is also included in the front surface of the opening OP in the pixel defining film 380 corresponding to the green light emitting area.

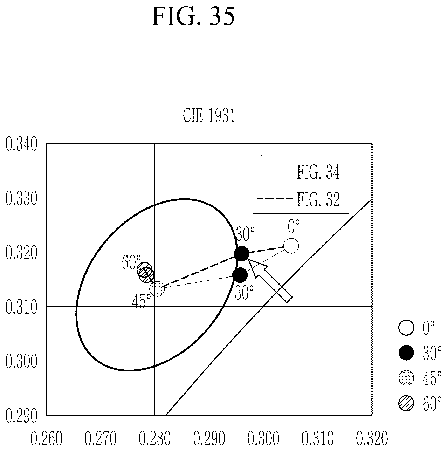

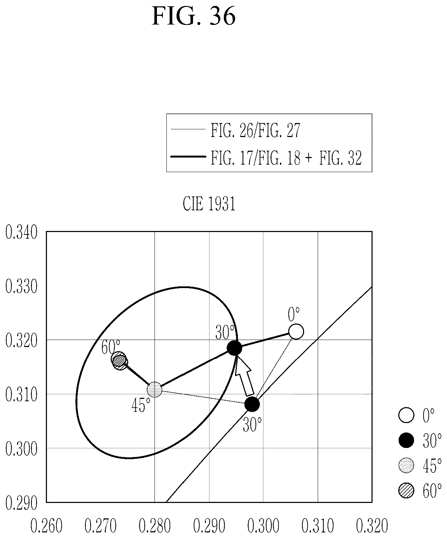

Hereinafter, the characteristics of the embodiments shown in FIG. 32 and FIG. 34 and the characteristics of the embodiments described with respect to FIG. 17, FIG. 18, FIG. 26, and FIG. 27 described above will be described with reference to FIG. 35 and FIG. 36.

FIG. 35 and FIG. 36 are graphs of color coordinate values according to angles.

First, FIG. 35 shows color coordinates at a specific angle based on the front for the embodiment shown in FIG. 32 and the embodiment shown in FIG. 34 on CIE 1931 color coordinates.

Referring to FIG. 35, the color coordinate values at 30° based on the front are less reddish in the embodiment shown in FIG. 32 than in the embodiment shown in FIG. 34. That is, as shown in FIG. 32, when the insulating layer lens OPMLP is formed in front of the opening OP in the pixel defining film 380 corresponding to the red and blue light emitting areas and when the insulating layer lens OPMLP is not formed in front of the opening OP in the pixel defining film 380 corresponding to the green light emitting area, the reddish phenomenon is reduced as the red and blue light are decreased and the green light is increased at the side.

In FIG. 36, the difference between the embodiment shown in FIG. 32 and the embodiment shown in FIG. 26 and FIG. 27 in front of the embodiment shown in FIG. 17 and FIG. 18 is shown on CIE 1931 color coordinates.

As seen in FIG. 36, the color coordinate values at 30° based on the front are less reddish in the embodiment shown in FIG. 17 and FIG. 18 than in the embodiments shown in FIG. 26 and FIG. 27. Therefore, when the embodiment shown in FIG. 17 and FIG. 18 is combined with the embodiment shown in FIG. 32, the color coordinate values at 30° based on the front are the least reddish.

Therefore, an embodiment that may most reduce the degree of the red light included in the color coordinate value at 30° based on the front is the embodiment in which planarization is performed by using a slit mask only on the second organic film 182 positioned under the anode included in the green light emitting diode LED and the insulating layer lens OPMLP is formed only on the front surfaces of the red and blue light emitting diodes LED, as in the embodiments shown in FIG. 17 and FIG. 18.

However, because the embodiments shown in FIG. 17 and FIG. 18 and the embodiment shown in FIG. 32 individually reduce red light in the color coordinate values at 30° based on the front, they may be individually applied. In addition, the embodiments shown in FIG. 17 and FIG. 18 and the embodiment shown in FIG. 34 may be formed together, and the embodiment shown in FIG. 32 and the embodiments shown in FIG. 26 and FIG. 27 may be formed together. Therefore, in some embodiments, planarization may be performed by using a slit mask only on the second organic film 182 positioned under the anode included in the green light emitting diode LED, and the insulating layer lens OPMLP may be formed in the front of the light emitting diodes LED of all colors. In addition, planarization may be performed by using a slit mask on the organic film positioned under the anodes included in the light emitting diodes LED of all colors, and the insulating layer lens OPMLP may be formed only on the front surfaces of the red and blue light emitting diodes LED.

When the light blocking member 220 and the color filter 230 are formed on the front surface of the light emitting display device without forming a polarizer, problems caused by external light may occur, but by using the encapsulation layer having the structure shown in FIG. 37, reflection characteristics of external light may be reduced (or improved).

FIG. 37 illustrates a cross-sectional view of a detailed structure of an encapsulation layer according to an embodiment.

In FIG. 37, the encapsulation layer 400 positioned between the cathode (Cathode) and the lower sensing insulating layer 501 is shown, and in the embodiment shown in FIG. 37, a capping layer CPL is further included between the cathode (Cathode) and the encapsulation layer 400. The capping layer CPL may be made of a material having a refractive index of about 2.0, and may have a thickness in a range of about 500 Å to about 700 Å.

The encapsulation layer 400 protects the light emitting layer EML made of an organic material from moisture or oxygen that may be introduced from the outside, and in FIG. 37, also lowers a reflection characteristic of external light in the light emitting display device in which external light may be reflected because no polarizer is additionally attached.

The encapsulation layer 400 shown in FIG. 37 may be generally divided into a first inorganic encapsulation layer 410, an organic encapsulation layer 420, and a second inorganic encapsulation layer 430. Here, the first inorganic encapsulation layer 410 and the second inorganic encapsulation layer 430 may be respectively formed by a chemical vapor deposition (CVD) method and are indicated as 1^{st} CVD and 2^{nd} CVD.

The first inorganic encapsulation layer 410 may be divided into a plurality of inorganic insulating layers having different refractive indexes. In FIG. 37, two embodiments are shown, which will be described as follows.

The first inorganic encapsulation layer 410 may include a (1-1)-th inorganic encapsulation layer 401, a (1-2)-th inorganic encapsulation layer 402, and a (1-3)-th inorganic encapsulation layer 403. Here, the (1-1)-th inorganic encapsulation layer 401 may be an inorganic film having a refractive index of 1.57, the (1-2)-th inorganic encapsulation layer 402 may be an inorganic film having a refractive index of 1.77, and the (1-3)-th inorganic encapsulation layer 403 may be an inorganic film having a refractive index of 1.62. Based on the refractive index, the refractive index of the (1-2)-th inorganic encapsulation layer 402 is the largest, the refractive index of the (1-3)-th inorganic encapsulation layer 403 is second, and the refractive index of the (1-1)-th inorganic encapsulation layer 401 is the smallest.

The (1-1)-th inorganic encapsulation layer 401 may have a thickness in a range of about 1000 Å to about 1500 Å, the (1-2)-th inorganic encapsulation layer 402 may have a thickness in a range of about 8000 Å to about 10000 Å, and the (1-3)-th inorganic encapsulation layer 403 may have a thickness in a range of about 500 Å to about 900 Å. Based on the thickness, the (1-2)-th inorganic encapsulation layer 402 is the thickest, followed by the (1-1)-th inorganic encapsulation layer 401, and the (1-3)-th inorganic encapsulation layer 403 is the thinnest.

In another embodiment, the first inorganic encapsulation layer 410 may further include a (1-4)-th inorganic encapsulation layer 404 on the (1-3)-th inorganic encapsulation layer 403. The (1-1)-th inorganic encapsulation layer 401 may be a silicon oxynitride (SiOₓN_{y}) film having a refractive index of 1.57, the (1-2)-th inorganic encapsulation layer 402 may be a silicon oxynitride (SiOₓN_{y}) film having a refractive index of 1.77, the (1-3)-th inorganic encapsulation layer 403 may be a silicon oxynitride (SiOₓN_{y}) film having a refractive index of 1.62, and the (1-4)-th inorganic encapsulation layer 404 may be a silicon oxynitride (SiOₓN_{y}) film have a refractive index of 1.52, that is, having a low refractive index due to a high oxygen content. Based on the refractive index, the refractive index of the (1-2)-th inorganic encapsulation layer 402 is the largest, the refractive index of the (1-3)-th inorganic encapsulation layer 403 is the next largest, the refractive index of the (1-1)-th inorganic encapsulation layer 401 is the next largest, and the refractive index of the (1-4)-th inorganic encapsulation layer 404 is the smallest.

Here, the (1-1)-th inorganic encapsulation layer 401 may have a thickness in a range of about 1000 Å to about 1500 Å, the (1-2)-th inorganic encapsulation layer 402 may have a thickness in a range of about 8000 Å to about 10,000 Å, the (1-3)-th inorganic encapsulation layer 403 may have a thickness in a range of about 500 Å to about 900 Å, and the (1-4)-th inorganic encapsulation layer 404 may have a thickness in a range of about 600 Å to about 1000 Å. Based on the thickness, the (1-2)-th inorganic encapsulation layer 402 is the thickest, the (1-1)-th inorganic encapsulation layer 401 is the next thickest, the (1-4)-th inorganic encapsulation layer 404 is the next thickest, and the (1-3)-th inorganic encapsulation layer 403 is the thinnest.

The organic encapsulation layer 420 is positioned on the first inorganic encapsulation layer 410, and the organic encapsulation layer 420 may be formed of a monomer having a refractive index of 1.52. The organic encapsulation layer 420 may have a thickness in a range of about 7 µm to about 10 µm. The organic encapsulation layer 420 may be formed to have a thicker thickness than the first inorganic encapsulation layer 410 and the second inorganic encapsulation layer 430.

The second inorganic encapsulation layer 430 is positioned on the organic encapsulation layer 420, and the second inorganic encapsulation layer 430 may be an inorganic film having a refractive index of 1.89. The second inorganic encapsulation layer 430 may also be a silicon oxynitride (SiOₓN_{y}) film. The second inorganic encapsulation layer 430 may have a thickness in a range of about 4000 Å to 6000 Å. The second inorganic encapsulation layer 430 may have a thinner thickness than the first inorganic encapsulation layer 410.

The encapsulation layer 400 according to the embodiment shown in FIG. 37, particularly, the first inorganic encapsulation layer 410, includes several layers having different refractive indexes to have a characteristic of allowing some reflection when external light is incident so that even if external light is incident and reflected because no polarizer is attached, some of the light is reflected before being reflected from the anode to reduce an amount of light reflected on the anode so that the reflection characteristics may be dispersed to not be easily visible to a user.

In some embodiments, the organic encapsulation layer 420 may be formed around the display area DA, the first inorganic encapsulation layer 410 and the second inorganic encapsulation layer 430 may be positioned up to the non-display area PA, and end portions of one side of the first inorganic encapsulation layer 410 and the second inorganic encapsulation layer 430 may be in direct contact with each other.

Herein, an embodiment in which the portion corresponding to the blue light emitting area is formed identically to the red light emitting area has been described. However, in some embodiments, the blue light emitting area may be additionally planarized similar to the green light emitting area or the insulating layer lens OPMLP may not be formed therein.

While this invention has been described in connection with what is presently considered to be practical embodiments, it is to be understood that the present invention is not limited to the disclosed embodiments.

It is clear for those of ordinary skill in the art that the disclosed embodiments can be combined where possible.

**Description of Some Symbols**

| | | | |
|---|---|---|---|
| DP: | display panel | OPS: | optical sensor area |
| DA: | display area | Mask: | mask |
| HEA, HEA1, HEA1g, HEA2, HEA2g: | halftone exposure area | | |
| 110: | substrate | 111: | buffer layer |
| 141, 142, 143: | gate insulating film | 161, 162: | interlayer insulating film |
| 181, 182, 183: | organic film | 400: | encapsulation layer |
| 401, 403: | Inorganic encapsulation layer | | |
| 402: | organic encapsulation layer | | |
| 501, 510, 511: | sensing insulating layer | | |
| 550: | planarization layer | | |
| 127, 128, 151, 152, 153, 155, 171, 172, 741: | wire | | |
| 385, 385-1, 385-2: | spacer | BML: | metal layer |
| EL: | light emitting layer | FL: | functional layer |
| OP4: | opening for anode connection | OP3: | lower organic film opening |
| 380: | black pixel defining film | | |
| OP: | opening of black pixel defining film | | |
| 220: | light blocking member | | |
| OPBM: | opening of light blocking member | | |
| 230R, 230G, 230B: | color filter | 540, 541: | sensing electrode |
| FL-SD1, FL-SD2: | extension | CPL: | capping layer |
| 650: | first insulating layer | 660: | second insulating layer |
| OPMLP: | insulating layer lens/opening | | |

## Claims

1. A light emitting display device (1000) comprising:
a substrate (110);
a green light emitting diode (LED) comprising a first anode (Anode), a red light emitting diode (LED) comprising a second anode (Anode), and a blue light emitting diode (LED) comprising a third anode (Anode), the first, second, and third anodes (Anode) being on the substrate (110);
a black pixel defining film (380) having an opening (OP) exposing the first anode (Anode), an opening (OP) exposing the second anode (Anode), and an opening (OP) exposing the third anode (Anode);
a cathode (Cathode) on the black pixel defining film (380), the first anode (Anode), the second anode (Anode), and the third anode (Anode);
an encapsulation layer (400) covering the cathode (Cathode);
a first insulating layer (650) on the encapsulation layer (400) and having a plurality of openings (OPMLP) overlapping the opening (OP) exposing the second anode (Anode) and the opening (OP) exposing the third anode (Anode) in a plan view; and
a second insulating layer (660) on the first insulating layer (650), in the plurality of openings (OPMLP) in the first insulating layer (650), and having a higher refractive index than the first insulating layer (650),
**characterized in that**
the first insulating layer (650) does not have an opening (OPMLP) corresponding to the opening (OP) exposing the first anode (Anode).

2. The light emitting display device (1000) of claim 1, further comprising an organic film (181, 182, 183) between the substrate (110) and the first anode (Anode), the second anode (Anode), and the third anode (Anode),
wherein the organic film (181, 182, 183) has a halftone exposure area (HEA, HEA1, HEA1g, HEA2, HEA2g) overlapping at least one of the first anode (Anode), the second anode (Anode), and the third anode (Anode) in the plan view, and a step of the halftone exposure area (HEA, HEA1, HEA1g, HEA2, HEA2g) is 30 nm or less.

3. The light emitting display device (1000) of claim 2, wherein the halftone exposure area (HEA, HEA1, HEA1g, HEA2, HEA2g) overlaps the first anode (Anode) in the plan view, and
wherein the second anode (Anode) and the third anode (Anode) do not overlap the halftone exposure area (HEA, HEA1, HEA1g, HEA2, HEA2g) in the plan view.

4. The light emitting display device (1000) of claim 2 or 3, further comprising a second data conductive layer (SD2) between the substrate (110) and the organic film (181, 182, 183),
wherein the organic film (181, 182, 183) comprises a lower organic film (182) and an upper organic film (183),
wherein the halftone exposure area (HEA, HEA1, HEA1g, HEA2, HEA2g) at a portion overlapping the first anode (Anode) in the plan view is on the lower organic film (182), and
wherein the halftone exposure area (HEA, HEA1, HEA1g, HEA2, HEA2g) is not on the upper organic film (183).

5. The light emitting display device (1000) of any one of the preceding claims, further comprising a light blocking member (220) on the second insulating layer (660) and having an opening (OPBM); and
a color filter (230, 230B, 230G, 230R) filling the opening (OPBM) in the light blocking member (220).

6. The light emitting display device (1000) of claim 5, wherein a polarizer is not on the light blocking member (220) and the color filter (230, 230B, 230G, 230R).

7. The light emitting display device (1000) of any one of claims 4 to 6, further comprising a first data conductive layer (SD1) between the substrate (110) and the second data conductive layer (SD2),
wherein the first data conductive layer (SD1) has a first extension (FL-SD1) overlapping the first anode (Anode) in the plan view, and
wherein the second data conductive layer (SD2) has a plurality of second extensions (FL-SD2) respectively overlapping the second anode (Anode) and the third anode (Anode) in the plan view.

8. The light emitting display device (1000) of any one of the preceding claims, wherein the encapsulation layer (400) comprises a first inorganic encapsulation layer (410), an organic encapsulation layer (420), and a second inorganic encapsulation layer (430), and
wherein the first inorganic encapsulation layer (410) comprises a (1-1)-th inorganic encapsulation layer (401), a (1-2)-th inorganic encapsulation layer (402), and a (1-3)-th inorganic encapsulation layer (403) that have different refractive indexes and thicknesses and that are sequentially stacked.

9. The light emitting display device (1000) of claim 8, wherein the refractive index of the (1-2)-th inorganic encapsulation layer (402) is the largest from among the layers of the first inorganic encapsulation layer (410), the refractive index of the (1-3)-th inorganic encapsulation layer (403) is the next largest, and the refractive index of the (1-1)-th inorganic encapsulation layer (401) is the smallest, and
wherein the (1-2)-th inorganic encapsulation layer (402) is the thickest from among the layers of the first inorganic encapsulation layer (410), the (1-1)-th inorganic encapsulation layer (401) is the next thickest, and the (1-3)-th inorganic encapsulation layer (403) is the thinnest.

10. The light emitting display device (1000) of claim 8 or 9, wherein the first inorganic encapsulation layer (410) further comprises a (1-4)-th inorganic encapsulation layer (404) having a low refractive index and being on the (1-3)-th inorganic encapsulation layer (403).

## Patentansprüche

1. Lichtemittierende Anzeigevorrichtung (1000), umfassend:
ein Substrat (110);
eine grüne Leuchtdiode (LED) mit einer ersten Anode (Anode), eine rote Leuchtdiode (LED) mit einer zweiten Anode (Anode) und eine blaue Leuchtdiode (LED) mit einer dritten Anode (Anode), wobei sich die erste, zweite und dritte Anode (Anode) auf dem Substrat (110) befinden;
einen schwarzen Pixel definierenden Film (380) mit einer Öffnung (OP), die die erste Anode (Anode) freilegt, einer Öffnung (OP), die die zweite Anode (Anode) freilegt, und einer Öffnung (OP), die die dritte Anode (Anode) freilegt;
eine Kathode (Kathode) auf dem schwarzen Pixel definierenden Film (380), der ersten Anode (Anode), der zweiten Anode (Anode) und der dritten Anode (Anode);
eine die Kathode (Kathode) bedeckende Verkapselungsschicht (400);
eine erste Isolierschicht (650) auf der Verkapselungsschicht (400), die mehrere Öffnungen (OPMLP) aufweist, die in der Draufsicht die Öffnung (OP), die die zweite Anode (Anode) freilegt, und die Öffnung (OP), die die dritte Anode (Anode) freilegt, überlappen; und
eine zweite Isolierschicht (660) auf der ersten Isolierschicht (650), die sich in den mehreren Öffnungen (OPMLP) in der ersten Isolierschicht (650) befindet und einen höheren Brechungsindex als die erste Isolierschicht (650) aufweist,
**dadurch gekennzeichnet, dass**
die erste Isolierschicht (650) keine Öffnung (OPMLP) aufweist, die der Öffnung (OP) entspricht, die die erste Anode (Anode) freilegt.

2. Lichtemittierende Anzeigevorrichtung (1000) nach Anspruch 1, umfassend ferner einen organischen Film (181, 182, 183) zwischen dem Substrat (110) und der ersten Anode (Anode), der zweiten Anode (Anode) und der dritten Anode (Anode),
wobei der organische Film (181, 182, 183) einen Halbton-Belichtungsbereich (HEA, HEA1, HEA1g, HEA2, HEA2g) aufweist, der in der Draufsicht mindestens eine von der ersten Anode (Anode), der zweiten Anode (Anode) und der dritten Anode (Anode) überlappt, wobei eine Stufe des Halbton-Belichtungsbereichs (HEA, HEA1, HEA1g, HEA2, HEA2g) 30 nm oder weniger beträgt.

3. Lichtemittierende Anzeigevorrichtung (1000) nach Anspruch 2, wobei der Halbton-Belichtungsbereich (HEA, HEA1, HEA1g, HEA2, HEA2g) in der Draufsicht die erste Anode (Anode) überlappt, und
wobei die zweite Anode (Anode) und die dritte Anode (Anode) in der Draufsicht den Halbton-Belichtungsbereich (HEA, HEA1, HEA1g, HEA2, HEA2g) nicht überlappen.

4. Lichtemittierende Anzeigevorrichtung (1000) nach Anspruch 2 oder 3, umfassend ferner eine zweite datenleitende Schicht (SD2) zwischen dem Substrat (110) und dem organischen Film (181, 182, 183),
wobei der organische Film (181, 182, 183) einen unteren organischen Film (182) und einen oberen organischen Film (183) umfasst,
wobei sich der Halbton-Belichtungsbereich (HEA, HEA1, HEA1g, HEA2, HEA2g) in einem Abschnitt, der in der Draufsicht die erste Anode (Anode) überlappt, auf dem unteren organischen Film (182) befindet, und
wobei sich der Halbton-Belichtungsbereich (HEA, HEA1, HEA1g, HEA2, HEA2g) nicht auf dem oberen organischen Film (183) befindet.

5. Lichtemittierende Anzeigevorrichtung (1000) nach einem der vorstehenden Ansprüche, umfassend ferner ein Lichtsperrelement (220) auf der zweiten Isolierschicht (660), das eine Öffnung (OPBM) aufweist; und
einen Farbfilter (230, 230B, 230G, 230R), der die Öffnung (OPBM) im Lichtsperrelement ausfüllt (220) ausfüllt.

6. Lichtemittierende Anzeigevorrichtung (1000) nach Anspruch 5, wobei sich kein Polarisator auf dem Lichtsperrelement (220) und dem Farbfilter (230, 230B, 230G, 230R) befindet.

7. Lichtemittierende Anzeigevorrichtung (1000) nach einem der Ansprüche 4 bis 6, umfassend ferner eine erste datenleitende Schicht (SD1) zwischen dem Substrat (110) und der zweiten datenleitenden Schicht (SD2),
wobei die erste datenleitende Schicht (SD1) eine erste Verlängerung (FL-SD1) aufweist, die in der Draufsicht die erste Anode (Anode) überlappt, und
wobei die zweite datenleitende Schicht (SD2) mehrere zweite Verlängerungen (FL-SD2) aufweist, die in der Draufsicht jeweils die zweite Anode (Anode) bzw. die dritte Anode (Anode) überlappen.

8. Lichtemittierende Anzeigevorrichtung (1000) nach einem der vorstehenden Ansprüche, wobei die Verkapselungsschicht (400) eine erste anorganische Verkapselungsschicht (410), eine organische Verkapselungsschicht (420) und eine zweite anorganische Verkapselungsschicht (430) umfasst, und
wobei die erste anorganische Verkapselungsschicht (410) eine (1-1)-te anorganische Verkapselungsschicht (401), eine (1-2)-te anorganische Verkapselungsschicht (402) und eine (1-3)-te anorganische Verkapselungsschicht (403) umfasst, die unterschiedliche Brechungsindizes und Dicken aufweisen und nacheinander gestapelt sind.

9. Lichtemittierende Anzeigevorrichtung (1000) nach Anspruch 8, wobei der Brechungsindex der (1-2)-ten anorganischen Verkapselungsschicht (402) unter den Schichten der ersten anorganischen Verkapselungsschicht (410) der größte ist, der Brechungsindex der (1-3)-ten anorganischen Verkapselungsschicht (403) der nächstgrößte ist und der Brechungsindex der (1-1)-ten anorganischen Verkapselungsschicht (401) der kleinste ist, und
wobei die (1-2)-te anorganische Verkapselungsschicht (402) unter den Schichten der ersten anorganischen Verkapselungsschicht (410) die dickste ist, die (1-1)-te anorganische Verkapselungsschicht (401) die nächstdickste ist und die (1-3)-te anorganische Verkapselungsschicht (403) die dünnste ist.

10. Lichtemittierende Anzeigevorrichtung (1000) nach Anspruch 8 oder 9, wobei die erste anorganische Verkapselungsschicht (410) ferner eine (1-4)-te anorganische Verkapselungsschicht (404) umfasst, die einen niedrigen Brechungsindex aufweist und sich auf der (1-3)-ten anorganischen Verkapselungsschicht (403) befindet.

## Revendications

1. Dispositif d'affichage électroluminescent (1000) comportant :
un substrat (110) ;
une diode électroluminescente (DEL) verte comportant une première anode (Anode), une diode électroluminescente (DEL) rouge comportant une deuxième anode (Anode) et une diode électroluminescente (DEL) bleue comportant une troisième anode (Anode), les première, deuxième et troisième anodes (Anode) étant sur le substrat (110) ;
un film de définition de pixel noir (380) présentant une ouverture (OP) exposant la première anode (Anode), une ouverture (OP) exposant la deuxième anode (Anode), et une ouverture (OP) exposant la troisième anode (Anode) ;
une cathode (Cathode) sur le film de définition de pixel noir (380), la première anode (Anode), la deuxième anode (Anode) et la troisième anode (Anode) ;
une couche d'encapsulation (400) recouvrant la cathode (Cathode) ;
une première couche isolante (650) sur la couche d'encapsulation (400) et présentant une pluralité d'ouvertures (OPMLP) chevauchant l'ouverture (OP) exposant la deuxième anode (Anode) et l'ouverture (OP) exposant la troisième anode (Anode) dans une vue en plan ; et
une deuxième couche isolante (660) sur la première couche isolante (650), dans la pluralité d'ouvertures (OPMLP) dans la première couche isolante (650), et présentant un indice de réfraction plus élevé que celui de la première couche isolante (650),
**caractérisé en ce que**
la première couche isolante (650) ne présente pas d'ouverture (OPMLP) correspondant à l'ouverture (OP) exposant la première anode (Anode).

2. Dispositif d'affichage électroluminescent (1000) selon la revendication 1, comportant en outre un film organique (181, 182, 183) entre le substrat (110) et la première anode (Anode), la deuxième anode (Anode) et la troisième anode (Anode),
dans lequel le film organique (181, 182, 183) présente une zone d'exposition demi-teinte (HEA, HEA1, HEA1g, HEA2, HEA2g) chevauchant au moins l'une parmi la première anode (Anode), la deuxième anode (Anode), et la troisième anode (Anode) dans la vue en plan, et une hauteur de marche de la zone d'exposition demi-teinte (HEA, HEA1, HEA1g, HEA2, HEA2g) est de 30 nm ou moins.

3. Dispositif d'affichage électroluminescent (1000) selon la revendication 2, dans lequel la zone d'exposition demi-teinte (HEA, HEA1, HEA1g, HEA2, HEA2g) chevauche la première anode (Anode) dans la vue en plan, et
dans lequel la deuxième anode (Anode) et la troisième anode (Anode) ne chevauchent pas la zone d'exposition demi-teinte (HEA, HEA1, HEA1g, HEA2, HEA2g) dans la vue en plan.

4. Dispositif d'affichage électroluminescent (1000) selon la revendication 2 ou 3, comportant en outre une deuxième couche conductrice de données (SD2) entre le substrat (110) et le film organique (181, 182, 183),
dans lequel le film organique (181, 182, 183) comporte un film organique inférieur (182) et un film organique supérieur (183),
dans lequel la zone d'exposition demi-teinte (HEA, HEA1, HEA1g, HEA2, HEA2g) au niveau d'une portion chevauchant la première anode (Anode) dans la vue en plan est sur le film organique inférieur (182), et
dans lequel la zone d'exposition demi-teinte (HEA, HEA1, HEA1g, HEA2, HEA2g) n'est pas sur le film organique supérieur (183).

5. Dispositif d'affichage électroluminescent (1000) selon l'une quelconque des revendications précédentes, comportant en outre un élément de blocage de lumière (220) sur la deuxième couche isolante (660) et présentant une ouverture (OPBM) ; et
un filtre coloré (230, 230B, 230G, 230R) remplissant l'ouverture (OPBM) dans l'élément de blocage de lumière (220).

6. Dispositif d'affichage électroluminescent (1000) selon la revendication 5, dans lequel un polariseur n'est pas sur l'élément de blocage de lumière (220) et le filtre coloré (230, 230B, 230G, 230R).

7. Dispositif d'affichage électroluminescent (1000) selon l'une quelconque des revendications 4 à 6, comportant en outre une première couche conductrice de données (SD1) entre le substrat (110) et la deuxième couche conductrice de données (SD2),
dans lequel la première couche conductrice de données (SD1) présente une première extension (FL-SD1) chevauchant la première anode (Anode) dans la vue en plan, et
dans lequel la deuxième couche conductrice de données (SD2) présente une pluralité de deuxièmes extensions (FL-SD2) chevauchant respectivement la deuxième anode (Anode) et la troisième anode (Anode) dans la vue en plan.

8. Dispositif d'affichage électroluminescent (1000) selon l'une quelconque des revendications précédentes, dans lequel la couche d'encapsulation (400) comporte une première couche d'encapsulation inorganique (410), une couche d'encapsulation organique (420), et une deuxième couche d'encapsulation inorganique (430), et
dans lequel la première couche d'encapsulation inorganique (410) comporte une couche d'encapsulation inorganique de rang (1-1) (401), une couche d'encapsulation inorganique de rang (1-2) (402), et une couche d'encapsulation inorganique de rang (1-3) (403) qui présentent des indices de réfraction et épaisseurs différents et qui sont empilées séquentiellement.

9. Dispositif d'affichage électroluminescent (1000) selon la revendication 8, dans lequel l'indice de réfraction de la couche d'encapsulation inorganique de rang (1-2) (402) est le plus élevé parmi les couches de la première couche d'encapsulation inorganique (410), l'indice de réfraction de la couche d'encapsulation inorganique de rang (1-3) (403) est le suivant le plus élevé, et l'indice de réfraction de la couche d'encapsulation inorganique de rang (1-1) (401) est le plus petit, et
dans lequel la couche d'encapsulation inorganique de rang (1-2) (402) est la plus épaisse parmi les couches de la première couche d'encapsulation inorganique (410), la couche d'encapsulation inorganique de rang (1-1) (401) est la suivante la plus épaisse, et la couche d'encapsulation inorganique de rang (1-3) (403) est la plus fine.

10. Dispositif d'affichage électroluminescent (1000) selon la revendication 8 ou 9, dans lequel la première couche d'encapsulation inorganique (410) comporte en outre une couche d'encapsulation inorganique de rang (1-4) (404) présentant un faible indice de réfraction et se trouvant sur la couche d'encapsulation inorganique de rang (1-3) (403).
